(19)

Europäisches
Patentamt
European
Patent Office
Office européen
des brevets

(11) **EP 2 197 039 A1**

(12) **EUROPEAN PATENT APPLICATION**
published in accordance with Art. 153(4) EPC

(43) Date of publication:
**16.06.2010 Bulletin 2010/24**

(51) Int Cl.:
***H01L 31/04*** *(2006.01)*

(21) Application number: **08834457.7**

(22) Date of filing: **26.09.2008**

(86) International application number:
**PCT/JP2008/067556**

(87) International publication number:
**WO 2009/041657 (02.04.2009 Gazette 2009/14)**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **28.09.2007 JP 2007255646
30.03.2008 JP 2008088956**

(71) Applicant: **Fujifilm Corporation
Tokyo 106-8620 (JP)**

(72) Inventors:
• **AONO, Naruhiko
Ashigarakami-gun
Kanagawa 258-8577 (JP)**

• **HOSOYA, Youichi
Ashigarakami-gun
Kanagawa 258-8577 (JP)**
• **YAGO, Haruo
Ashigarakami-gun
Kanagawa 258-8577 (JP)**
• **SATO, Tadanobu
Ashigarakami-gun
Kanagawa 258-8577 (JP)**

(74) Representative: **HOFFMANN EITLE
Patent- und Rechtsanwälte
Arabellastrasse 4
81925 München (DE)**

(54) **SUBSTRATE FOR SOLAR CELL AND SOLAR CELL**

(57) A substrate for a solar cell having a metal substrate, a first insulating oxide film formed on the metal substrate by anodic oxidation, and a second insulating film, wherein the first insulating oxide film has pores and the pores are sealed with the second insulating film at a sealing ratio of 5 to 80%.

**EP 2 197 039 A1**

**Description**

TECHNICAL FIELD

The present invention relates to a substrate for a solar cell that has flexibility and excellent voltage resistance characteristics and provides excellent adhesion properties to an upper layer to form a thin-film solar cell; and also relates to a solar cell using the same.

BACKGROUND ART

Glass substrates are mainly used as thin-film solar cell substrates. However, a glass substrate is fragile and must be treated with considerable care and its lack of flexibility limits the scope of the application. Recently, solar cells have attracted much attention as power supply sources to buildings including homes. It is inevitable to upsize solar cells in order to ensure sufficient electric power to supply, and there has been a demand for a more lightweight substrate that should contribute to production of solar cells with larger areas.
However, a glass substrate would be even more fragile if it is thinned for reduction in weight. Therefore, there has been a demand for development of a less fragile and more flexible substrate material that can be reduced in weight as compared to the glass substrate.

The glass substrate is relatively expensive as compared to a photoelectric conversion layer material for a solar cell, and an inexpensive substrate material is desired in the expectation that such an inexpensive material will help promote the use of solar cells. If a metal is used as such a substrate material, its insulation from a solar cell material arranged thereon is difficult, while a resin substrate cannot withstand a high temperature exceeding 400°C that is necessary to form a solar cell.

Use of a metal substrate also causes a problem in which the thermal expansion coefficient of the metal substrate differs from that of the semiconductor layer of the photoelectric conversion layer, so that the semiconductor layer is susceptible to peeling. To deal with this problem, JP-A-2006-80370 ("JP-A" means unexamined published Japanese patent application) discloses that a glass layer containing 40 to 60 wt% of $SiO_2$, 15 to 30 wt% of $B_2O_3$, 2 to 10 wt% of $Na_2O$, and 8 to 20 wt% of $TiO_2$ is formed on the metal substrate. Further, JP-A-2006-295035 discloses that a first insulating layer is formed on a metal material by a sol-gel method and further a second insulating layer of another insulating material is formed to insulate remaining pinholes. However, this method also has a problem that a sufficient breakdown voltage is not obtained. Further, JP-A-2000-349320 discloses that an anodic oxidation film with a thickness of 0.5 μm or more is formed as an insulating film. However, there is a problem in which when such an insulating layer is formed only on one side, the shape may be curved due to the difference in thermal expansion coefficient in this method during the process of manufacturing a solar cell.

The glass substrate has sufficient insulating properties but cannot be flexible or lightweight. The metal substrate is highly flexible and lightweight but cannot have reliable insulating properties. It is difficult to develop a substrate having insulating properties, flexibility and light weight at the same time.

It is known that copper-indium-gallium-selenium-based (CIGS-based) solar batteries can have improved electric generation efficiency, when sodium (Na) is diffused into their light absorption layer. In conventional technology, a blue plate glass substrate is used so that Na contained in the blue plate glass can be diffused into the light absorption layer. However, when a material other than blue plate glass, such as a metal plate is used as a substrate for solar batteries, a problem occurs in which Na has to be supplied separately. For example, therefore, JP-A-10-74966 and JP-A-10-74967 disclose mixing and vapor-depositing $Na_2Se$, JP-A-09-55378 discloses mixing and vapor-depositing $Na_2O$, and JP-A-10-125941 discloses mixing and vapor-depositing $Na_2S$. JP-A-2005-117012 discloses vapor deposition of sodium phosphate on molybdenum (Mo). JP-A-2006-210424 discloses deposition of a sodium molybdate-containing aqueous solution on a precursor. JP-A-2003-318424 and JP-A-2005-86167 disclose $Na_2S$ or $Na_2Se$ and $Na_3AlF_6$, respectively, which is provided between Mo and a substrate and/or a light absorption layer to supply Na. JP-A-08-222750 discloses precipitation of $Na_2S$ or $Na_2Se$ on a Mo electrode, and JP-A-2004-158556 and JP-A-2004-79858 disclose that a NaF coating is formed on Mo to supply Na.

In general, there is also a problem in which for example, a contact portion between an insulating layer and a back side electrode layer or a photoelectric conversion material layer is susceptible to peeling due to a difference in coefficient of thermal expansion or the like.

JP-A-2000-349320 discloses that $SiO_2$-containing pores are formed and sealed to provide insulating properties and flexibility. In this case, however, there is a problem in which alkali metal ions cannot be diffused into the photoelectric conversion layer.

DISCLOSURE OF INVENTION

The present invention has been made in view of the above circumstances. The present invention is to provide a substrate for a solar cell containing a metal substrate and an insulating layer provided thereon, which is flexible and lightweight and has good insulating properties and provides good adhesion between the insulating layer and a layer formed thereon, and to provide a solar cell produced therewith having good voltage resistance characteristics.

As a result of intensive investigations, the inventors have found that when a porous insulating oxide film is once formed on the surface of a metal substrate by anodizing the metal substrate, the insulating layer on the metal substrate can be improved by performing pore sealing treatment to fill the pores with an insulating material or pore sealing treatment with an alkaline solution or water vapor after the formation of the oxide film and that in such a case, the substrate metal can be prevented from migration leading to dielectric breakdown and from chemically combining with a constituent element of another layer. The inventors have also found that particularly when an aluminum substrate is used, pores produced in the surface of an oxide alumina layer formed by anodic oxidation has an anchor effect on a conducting layer (metal or semiconductor) formed on the alumina to improve the adhesion, so that the metal layer having a different (higher) coefficient of thermal expansion can be prevented from peeling. The present invention has been made based on these findings.

According to the present invention, there is provided the following means:

(1) A substrate for a solar cell comprising a metal substrate, a first insulating oxide film formed on the metal substrate by anodic oxidation, and a second insulating film, wherein the first insulating oxide film has pores and the pores are sealed with the second insulating film at a sealing ratio of 5 to 80%.

(2) The substrate for a solar cell as described in the above item (1), wherein the metal substrate is a substrate containing at least one metal selected from the group consisting of aluminum, zirconium, titanium, magnesium, niobium and tantalum.

(3) The substrate for a solar cell as described in the above item (1) or (2), wherein the metal substrate is an aluminum substrate.

(4) The substrate for a solar cell as described in any one of the above items (1) to (3), wherein a thickness of the anodic oxide film is 0.1 $\mu$m to 100 $\mu$m.

(5) The substrate for a solar cell as described in any one of the above items (1) to (4), wherein the anodic oxide film is formed on both surfaces of the metal substrate.

(6) The substrate for a solar cell as described in any one of the above items (1) to (5), wherein the anodic oxide film is formed on an end face and both surfaces of the metal substrate.

(7) The substrate for a solar cell as described in any one of the above items (1) to (6), wherein the second insulating film contains alkali metal ions.

(8) The substrate for a solar cell as described in any one of the above items (1) to (7), wherein the alkali metal ions contained in the second insulating film are Na ions.

(9) A solar cell comprising; the substrate for a solar cell as described in any one of the above items (1) to (7); and a photoelectric conversion layer provided on the substrate for a solar cell.

(10) The solar cell as described in the above item (9), wherein the photoelectric conversion layer comprises a semiconductor layer comprising at least one Group Ib element, at least one Group IIIb element and at least one Group VIb element.

(11) The solar cell as described in the above item (9) or (10), wherein the semiconductor layer comprises at least one element selected from the group consisting of copper (Cu), silver (Ag), gallium (Ga), indium (In), sulfur (S), selenium (Se), and tellurium (Te).

Other and further features and advantages of the invention will appear more fully from the following description, taking the accompanying drawings into consideration.

BRIEF DESCRIPTION OF DRAWINGS

[Fig. 1] Fig. 1 is a schematic cross-sectional view of an apparatus for water washing with a freely-falling curtain-like liquid film.

[Fig. 2] Figs. 2(a) to 2(d) are each a cross-sectional view of a device for illustrating a general method of producing cells of a CIGS thin-film solar cell.

[Fig. 3] Fig. 3 is a diagram showing the relationship between the lattice constant and the band gap of semiconductors composed of Group Ib elements, IIIb elements and VIb elements.

[Fig. 4] Fig. 4 is a diagram showing the band gap of a solar cell produced in the example.

BEST MODE FOR CARRYING OUT INVENTION

Hereinafter, the present invention will be described in detail.

[Substrate for Solar Cell]

The substrate for a solar cell of the present invention is **characterized in that** it is obtained by forming a first insulating oxide film having pores on a metal substrate by anodic oxidation and forming a second insulating film on the pores so that the pores can be sealed.

As the metal substrate for use in the present invention, a material capable of forming a metal oxide film as an insulator on its surface when subjected to anodic oxidation can be used. Examples of such a material include aluminum (Al), zirconium (Zr), titanium (Ti), magnesium (Mg), niobium (Nb), tantalum (Ta), and an alloy thereof. In view of cost and the characteristics required for solar cells, aluminum is most preferred. Hereinafter, the substrate for a solar cell will be described in detail, giving an aluminum substrate as an example.

<Aluminum Substrate>

An aluminum substrate may be used in an embodiment of the invention. Such an aluminum substrate is a dimensionally-stable metallic substrate including aluminum as a primary component, such as a substrate made of aluminum or an aluminum alloy. A pure aluminum sheet, an alloy sheet including aluminum as a primary component and a trace amount of a different element(s), or an aluminum- or aluminum alloy-laminated or vapor-deposited plastic film or paper sheet may also be used. Although the composition of the aluminum sheet for use in an embodiment of the invention is not restricted, a pure aluminum sheet is preferably used.

Such a high purity aluminum material preferably has a purity of 99.9% by mass or higher. As the purity of the aluminum material increases, the order of the pores becomes higher after the anodic oxidation, and the size (average pore period) of the region having the order also becomes wider. For electromagnetic device applications, therefore, an aluminum material having a purity as high as possible is preferably used. The purity is preferably 99.99% by mass or higher, more preferably 99.995% by mass or higher, further more preferably 99.999% by mass or higher. Many of commercially available materials with a purity of 99.9% by mass or higher to 99.99% by mass or lower have no blister, although they sometimes have rolling stripes. However, materials with a purity of higher than 99.99% by mass are generally available by special order and often produced with small-scale experimental equipment, when supplied, and they are generally sheet materials having blisters on one level or another.

Aluminum with a purity of 99.99% by mass to 99.999% by mass is generally called high purity aluminum, and aluminum with a purity in a range of 99.999% by mass or higher is called ultrahigh purity aluminum. An aluminum material with a purity of higher than 99.99% by mass is produced by repeated melting and refining in a melting furnace. In the melting process, agitation is performed using gas such as air or inert gas, and therefore, bubbles are trapped. Thereafter, degassing is performed under reduced pressure. In the case of high-purity materials, a very trace amount of impurities must be allowed to float on the surface layer, which requires strong agitation, so that the content of bubbles may be high and that degassing may tend to be insufficient. If such an aluminum material containing bubbles is rolled, a convex portion with a diameter of about 50 $\mu$m to about 2 mm or about 0.1 to about 1 mm and a depth of about 0.1 to about 20 $\mu$m or about 0.3 to about 10 $\mu$m, called "blister" may be formed. Such portions are generally formed at a density of several per $dm^2$ to hundreds per $dm^2$. Rolling stripes as mentioned above may also be generated by rolling.

Since completely pure aluminum is difficult to produce from the viewpoint of refining technology, the material to be used may contain a trace amount of a different element(s). For example, known materials as described in Aluminum Handbook, 4th ed. (Japan Light Metals Association (1990)), such as 1000 series alloy including JIS 1050 material and JIS 1100 material; 3000 series alloy including JIS 3003 material, JIS 3004 material and JIS 3005 material; 6000 series alloy including JIS 6061 material, JIS 6063 material and JIS 6101 material and internationally registered alloy 3103A may be used.

An aluminum alloy, a scrap aluminum material, or an aluminum sheet produced with secondary aluminum which has an aluminum (Al) content of 99.4 to 95% by mass and containing at least the following five kinds of iron (Fe), silicon (Si), copper (Cu), magnesium (Mg), manganese (Mn), zinc (Zn), chromium (Cr), and titanium (Ti) in amounts ranging as described below may also be used. In an embodiment of the invention, an aluminum alloy is preferably used for the substrate (support) of the solar cell. The aluminum alloy preferably contains Fe and Si, more preferably further contains Cu, and further more preferably further contains Ti.

The aluminum alloy (Al ingot) to be used as a raw material generally contains about 0.04 to 0.2% by mass of Fe. The amount of Fe present in the form of a solid solution in aluminum is small, and most of Fe is present in the form of an intermetallic compound. Fe is effective in increasing the mechanical strength of the aluminum alloy and has a significant effect on the strength of the support. If the Fe content is too low, the mechanical strength of the substrate may be too low, so that the substrate may be susceptible to breaking in the process of placing it in a vapor deposition apparatus and that the substrate may also be susceptible to breaking in the process of performing vapor deposition at high speed on a large number of substrates. If the Fe content is too high, the strength of the substrate may be unnecessarily high, so that the substrate may have a low level of fitness in the process of placing it in a vapor deposition apparatus and may be susceptible to breaking during vapor deposition. For example, if the Fe content is higher than 1.0% by mass, cracking may easily occur during rolling.

The upper limit of the Fe content is preferably 0.29% by mass, so that high mechanical strength can be obtained. In this case, the amount of the Fe-containing intermetallic compound is reduced, so that the number of local depressions formed after the intermetallic compound is removed (or drops off) is small, which leads to a reduction in defects of the crystal consisting the photoelectric conversion layer, favorable in-plane distribution of the electric generation efficiency, and high electric generation efficiency. In view of the Fe content of ingots, the lower limit of the Fe content is preferably and reasonably 0.05% or higher. The lower limit of the Fe content is more preferably 0.20% by mass or higher in terms of maintaining the mechanical strength. Examples of Fe-containing intermetallic compounds include $Al_3Fe$, $Al_6Fe$, Al-Fe-Si compounds, and Al-Fe-Si-Mn compounds.

Si is an inevitable impurity element, and an Al ingot as a raw material generally contains about 0.03 to about 0.1% by mass of Si. Si is often intentionally added in a very trace amount so that different raw materials will not cause variations. Si is also contained in a relatively large amount in scrap aluminum. Si is present in the form of a solid solution, an intermetallic compound or a simple precipitate in aluminum. When the solar cell substrate is heated in the manufacturing process, simple Si may be precipitated from a solid solution of Si. The inventors have found that Si has an effect on the anodizing treatment. In addition, if the Si content is too high, a defective anodic oxide film may be produced in the anodizing treatment.

In an embodiment of the invention, the Si content is preferably 0.03% by mass or higher and 0.15% by mass or lower. In order to restrain defects in the anodic oxide film, the amount is more preferably 0.04% by mass or more by mass, and 0.1 % by mass or less by mass.

Cu is a very important element for improving the heat resistance of aluminum. The Cu content is preferably 0.000% by mass or more, more preferably 0.020% by mass or more, so that the heat resistance of the aluminum can be improved and that the temperature range can be widened in the process of forming a photoelectric conversion layer. On the other hand, if the Cu content is more than 0.15% by mass, the film may suffer from dielectric breakdown during anodic oxidation, so that a uniform anodic oxide film surface cannot be obtained in some cases.

In an embodiment of the invention, the Cu content is preferably from 0.000 to 0.150% by mass, more preferably from 0.05 to 0.1% by mass, from the above point of view.

Ti has been used as a grain refining agent to refine the crystal structure during casting, and Ti is generally contained in a content of 0.05% by mass or lower. If the Ti content is too high, the film may suffer from dielectric breakdown during anodic oxidation, so that a uniform anodic oxide film surface cannot be obtained in some cases. In an embodiment of the invention, the Ti content is preferably 0.05% by mass or lower, more preferably 0.03% by mass or lower.

Ti does not have to be contained in the aluminum sheet, and the Ti content may be low. In order to enhance the grain refining effect, however, the Ti content is preferably 0.001% by mass or higher.

Ti is generally added in the form of an intermetallic compound with Al or in the form of $TiB_2$. In order to enhance the grain refining effect, however, Ti is preferably added in the form of an Al-Ti alloy or an Al-B-Ti alloy. When Ti is added in the form of an Al-B-Ti alloy, a very trace amount of boron (B) is also added to the aluminum alloy, which does not reduce the effect of the invention.

When the aluminum sheet containing the different elements in the above-mentioned amount-ranges is used, an uniform anodic oxide film is obtained by anodic oxidation treatment that will be detailed later. Thus, when the aluminum sheet is made into an insulating substrate for a solar cell, the insulating property thereof is excellent.

The balance of the aluminum sheet is preferably composed of Al and inevitable impurities. Most of the inevitable impurities are contained in the Al ingot. For example, when contained in an Al ingot with a purity of 99.7%, the inevitable impurities do not reduce the effect of the invention. For example, the inevitable impurities may be contained in amounts as described in L. F. Mondolfo, "Aluminum Alloys: Structure and Properties" (1976), and the like.

Examples of inevitable impurities contained in aluminum alloys include Mg, Mn, Zn, and Cr, each of which may be contained in an amount of 0.05% by mass or lower. Any additional element other than these elements may also be contained in an amount known in the art.

The aluminum sheet for use in an embodiment of the invention may be produced by a process including subjecting the above raw material to casting by a ordinary method, subjecting the cast product to an appropriate rolling process and appropriate heat treatment, for example, to produce a 0.1 to 0.7 mm thick product, and optionally performing a flatness correcting process. The thickness may be changed as appropriate.

Examples of methods that may be used to produce the aluminum sheet include a DC casting method, a method of performing DC casting, excluding soaking and/or annealing, and a continuous casting method.

[Manufacture of Solar Cell Substrate]

The substrate for a solar cell for use in the present invention is obtained by anodizing (anodic oxidation) the above-mentioned aluminum sheet and further subjecting the resultant to a specific pore sealing treatment (also referred to as "sealing" or "sealing treatment"). The production process thereof may include various steps besides the essential steps. For example, polishing treatment may be conducted before the anodic oxidation.

(Aluminum sheet Having a Surface wherein Irregularities are Made)

In the production of the substrate for a solar cell of the invention, the following may be used: an aluminum sheet having a surface wherein irregularities are made; or a sheet obtained by making irregularities in an aluminum sheet as described above by lamination rolling, transfer or the like in a final rolling step thereof, or some other steps.

(Manufacturing Process of Solar Cell Substrate)

It is preferred that the aluminum sheet is made into a substrate for a solar cell by causing this sheet to undergo a degreasing treatment step for removing adhering rolling oil, a de-smutting treatment step for dissolving smuts on the surface of the aluminum sheet, a mechanically polishing step and electrolytically polishing step for making the surface of the aluminum sheet smooth, an anodic oxidation treatment step for forming an anodic oxide film on the surface of the aluminum sheet, and a pore-sealing treatment for sealing micro-pores in the anodic oxide film.

The production of the substrate for a solar cell used in the present invention preferably includes a mechanically polishing treatment for making the smooth surface of the aluminum sheet with a buff or the like.

In addition to the mechanically polishing treatment, the production of the substrate for a solar cell according to the present invention may include, as a surface treatment step of the aluminum sheet, an electrolytically polishing treatment of conducting electrolysis by effect of a direct current in an acidic solution. In the production of the substrate for a solar cell according to the present invention, the polishing and the other individual treatment steps may be in accordance with a continuous method or an intermittent method. It is industrially preferred to use the continuous method. In an embodiment of the invention, a hydrophilizing treatment may also be performed as needed.

More specifically, the process for producing the substrate for a solar cell of the present invention is preferably a process of conducting (a) mechanically polishing treatment, (b) electrolytically polishing treatment, (c) anodic oxidation treatment, and (d) pore-sealing treatment in this order.

Preferred are also a process wherein the treatment (a) is omitted in the above-mentioned process, a process wherein the treatment (b) is omitted in the process, and a process wherein the treatments (a) and (b) are omitted in the process.

<Water Washing Treatment>

A water washing treatment is usually performed between respective treatments above so as not carry over the processing solution to the next step.

The water washing treatment is preferably a treatment where water washing is performed using an apparatus of effecting a water washing treatment with a liquid film in a free-fall curtain shape and then the aluminum sheet is further washed with water by using a spray tube.

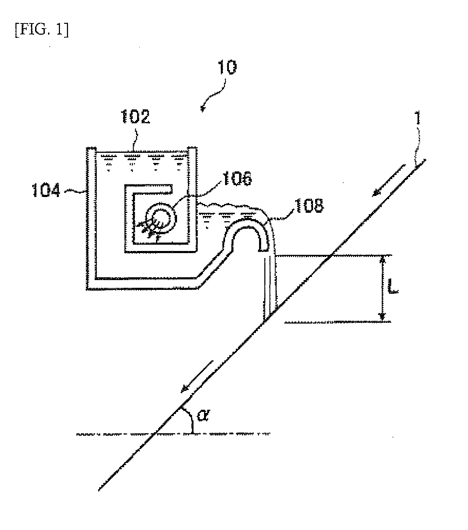

FIG. 1 is a schematic cross-sectional view of an apparatus of effecting a water washing treatment with a liquid film in a free-fall curtain shape. As shown in FIG. 1, an apparatus 10 of performing a water washing treatment with a liquid film in a free-fall curtain shape comprises a water storage tank 104 for storing water 102, a water supply tube 106 for supplying water to the water storage tank 104, and a flow controller part 108 for supplying a liquid film in a free-fall curtain shape from the water storage tank 104 to an aluminum sheet 1.

In the apparatus 10, water 102 is supplied from the water supply tube 106 to the water storage tank 104 and the water flow is controlled by the flow controller part 108 when the water 102 overflows from the water storage tank 104, whereby a liquid film in a free-fall curtain shape is supplied to the aluminum sheet 1. In the case of using the apparatus 10, the fluid volume is preferably from 10 to 100 L/min. Also, the distance L in which water 102 exists as a liquid film in a free-fall curtain shape between the apparatus 10 and the aluminum 1 is preferably from 20 to 50 mm. Furthermore, the angle $\alpha$ of the aluminum sheet is preferably from 30° to 80° with respect to the horizontal direction.

When an apparatus shown in FIG. 1 of effecting a water washing treatment with a liquid film in a free-fall curtain shape is used, a water washing treatment can be uniformly applied to the aluminum sheet and therefore, uniformity of the treatment performed before the water washing treatment can be enhanced.

Suitable examples of the apparatus of effecting a water washing treatment with a liquid film in a free-fall curtain shape include an apparatus described in JP-A-2003-96584.

As regards the spray tube for use in the water washing treatment, for example, a spray tube with a plurality of spray tips arranged in the width direction of the aluminum sheet and configured to fan out the injection water may be used. The distance between spray tips is preferably from 20 to 100 mm, and the fluid volume per one spray tip is preferably from 0.5 to 20 L/min. It is preferred to use a plurality of such spray tubes.

<Polishing Treatment>

Particularly when the plane roughness is desired to be small, a mechanical polishing process may be performed among various known metal surface treatment methods for removing relatively large asperities such as "blisters" and "rolling stripes. The mechanical polishing process is preferably followed by an auxiliary process such as a chemical polishing process or an electrochemical polishing process. The polishing method disclosed in JP-A-2007-30146 may be used.

When the surface roughness of the anodic oxidation layer is reduced by the process described below, the mechanical polishing process makes it possible to obtain an aluminum substrate with an arithmetic mean roughness Ra of 0.1 $\mu$m or less and a surface glossiness of 60% or higher.

(Arithmetic Mean Roughness Ra)

In general, the arithmetic mean roughness Ra of a metal surface is determined by a process including measuring the roughness of each of portions each having a standard length in the rolling direction and located in the transverse direction perpendicular to the rolling direction, and averaging the measurements. In an embodiment of the invention, the surface roughness is preferably determined by a profile curve method in which the contour of a cross section perpendicular to the surface of the object is determined, and the profile curve is preferably obtained using a contact-probe profilometer for an Ra of 1 $\mu$m or more or using an atomic force microscope (AFM) to measure the atomic force for an Ra of less than 1 $\mu$m. According to JIS B 601 (1994), a continuous part only with a standard length L is sampled from the roughness curve with respect to each of plural portions (for example, five portions), and the roughness of the sampled part is evaluated with respect to the length to be evaluated. The standard length may be the same as the cut-off value. Within the range of each standard length, various roughness parameters are determined, and the results are averaged with respect to the total number of the standard length portions. The average is used as a measurement. In an embodiment of the invention, the mean surface roughness may be the average of the measurements in the rolling direction and the direction perpendicular to the rolling direction.

(Surface Glossiness)

According JIS Z 8741, the surface of glass having a refractive index of 1.567 over the visible wavelength range (a specular reflectivity of 10% at an incidence angle of 60°) is defined as having a glossiness of 100 (%). However, the surface of glass with a refractive index of 1.567 is susceptible to erosion from moisture. Therefore, a glass surface with a refractive index of about 1.500 (a glossiness of 90%) may be used as a practical standard surface (the absolute value may be corrected every time so that the glossiness of the standard plate can be 90%).

When the glossiness of the surface of common materials is measured, a high glossiness should be measured at a small angle, while a low glossiness should be measured at a large angle. According to JIS, the angle is set to 20°, 45°, 60°, 75°, or 85°. In practice, however, a 60° gloss meter is often used, because of its wide measurement range. This is because the glossiness can be proportional to the angle, and therefore, even if not all the angles are used, the measurement at an angle allows estimation of the glossiness at another angle. According to JIS, the glossiness may be defined by percentage (%) or numerical value.

The glossiness is also called regular reflectance, which may be determined by a process including measuring plural portions in each of the longitudinal direction (parallel to the rolling direction) and the transverse direction (perpendicular to the rolling direction) and averaging the measurements in each direction. The aluminum substrate for use in an embodiment of the invention may have a glossiness of 60% or higher, preferably 80% or higher, in each of the longitudinal and transverse directions.

In an embodiment of the invention, the average arithmetic mean roughness and the average glossiness in each of the longitudinal direction and the transverse direction is preferably determined with respect to an area of 50 mm$^2$ or more, more preferably 400 mm$^2$ or more, further more preferably 900 mm$^2$ or more.

The aluminum substrate surface with an arithmetic mean roughness Ra of 0.1 $\mu$m or less and a surface glossiness of 60% or higher is considered to be substantially specular and free of visible scratches.

(Mechanical Polishing)

Mechanical polishing is a polishing technique including; embedding an abrasive-containing material such as a slurry of a mixture of water and an abrasive in a support material such as a cloth, a paper sheet or a metal, or supplying the abrasive-containing material to between the substrate to be polished and the polishing support material; and allowing them to rub against each other so that the substrate is polished with sharp portions of the abrasive. This technique allows mechanical treatment of a large area, delivers high grinding performance and is capable of removing deep scratches. Generally when the substrate is a thin sheet, it should be embedded in a resin material or attached to a metal block so that it can be formed into a shape susceptible to polishing. Particularly for mirror finish, it is called buffing, in which the polishing cloth and the abrasive are characteristic.

(1) Fine Polishing

A waterproof paper sheet or cloth coated with an abrasive such as SiC, diamond or alumina particles is preferably used as a polishing material. Particles with a particle size of about #80 (200 $\mu$m) to #4000 (4 $\mu$m) may be used. Examples of polishing materials include an abrasive paper sheet composed of waterproof paper and SiC powder embedded therein, a fine grinder composed of a metal and diamond powder embedded therein, and a napped fabric (generally called buff) for use in combination with a slurry or paste including a mixture of an abrasive and water or chemicals.

Abrasives or polishing cloths are preferably used in the order of small number (large particle size) to large number (small particle size) stepwise. Buffing may be performed with a coarse abrasive without performing fine polishing. However, any residual of the course abrasive may cause scratches, and, therefore, it is preferred to perform fine polishing with an abrasive-coated waterproof paper sheet or cloth. The waterproof paper sheet or cloth is preferably changed for every abrasive.
Specific examples: Polishing Cloth DP-Net (product name), manufactured by Marumoto Struers K.K., 6 $\mu$m to 45 $\mu$m in particle size (various types); Polishing Cloth DP-Nap (product name), manufactured by Marumoto Struers K.K., 0.25 $\mu$m to 1 $\mu$m in particle size (various types); and Waterproof Abrasive Paper #80 to #1500 (product name), manufactured by Marumoto Struers K.K. (various types).

(2) Buffing

Buffing is a technique including; providing a buff based on such a material as a cotton cloth, a sisal linen cloth, or wool fibers; rotating, at high speed, the buff with an abrasive bonded to the circumference surface with an adhesive (such as glue) or rotating the buff at high speed, while an abrasive is temporarily held on the surface of the rotating buff; and pressing a workpiece against the rotating surface to polish the material surface so that a uniform surface can be obtained.

a) Polishing Machine

A buffing machine is a polishing machine that performs working with a buff attached to the end of the shaft and rotating at high speed and with an abrasive held on the circumference surface of the buff. Various commercially-available polishing machines may be used, known examples of which include LaboPol-5 (trade name), RotoPol-35 (trade name) and MAPS (trade name) all manufactured by Marumoto Struers K.K.
Polishing may be performed manually or automatically using a tool as needed.

b) Buffs

Examples of buffs include cloth buffs such as sewn buffs, stitched buffs, loose buffs, bias buffs, and sisal buffs; and other buffs such as flap wheels, nonwoven wheels, and wire wheels. These buffs may be used depending on the intended use. Napped cotton buffs are preferred. Specific examples: product names, Polishing Cloth Nos. 101 (wool), 102 (cotton), 103 (synthetic fibbers), and 773 (a blend of cotton and synthetic fibers), manufactured by Marumoto Struers K.K.

c) Abrasive

The term "buffing abrasive" refers to an abrasive material that contains relatively fine abrasive particles as a primary component and is prepared by homogeneously mixing the particles with a medium composed of grease and other suitable components. Specific Example: Waterproof Abrasive Paper #80 to #1500 (product name), manufactured by Marumoto Struers K.K. (various types).

c-1) Grease-Based Abrasive

The term "grease-based abrasive" refers to an abrasive produced by kneading fine abrasive particles with grease and solidifying the resulting mixture, which is mainly used for mid-stage polishing or finish polishing in a buffing process. The greases commonly used include stearic acid, paraffin, tallow, and rosin. When the grease-based abrasive is pressed against a buff, the grease is molten by the frictional heat, so that the abrasive particles move to the buff surface along with the grease. When a metal article is pressed against the buff, the grease forms an oil film on the surface of the metal, so that unnecessary biting of the abrasive particles into the metal surface is prevented, which serves to smooth the metal surface. Examples of the grease-based abrasive include emery paste, tripoli, gloss, lime, green rouge, red rouge, white rouge, and grease stick. Particularly preferred are tripoli (primary component, $SiO_2$; Mohs hardness, 7), machiless (phonetic) (primary component, $CaO$; Mohs hardness, 2), green rouge (primary component, $Cr_2O_3$; Mohs hardness, 6), and white rouge (primary component, $Al_2O_3$; Mohs hardness, 9).

c-2) Liquid abrasive

A liquid abrasive is an abrasive produced for use in an automatic buffing machine and produced in the form of a liquid for automatic supply to the buffing machine. A method includes spraying the abrasive from a spray gun and controlling the opening/closing of the nozzle of the spray gun in response to the operation of a timer so that the abrasive can be intermittently sprayed. Known examples include liquid abrasives containing SiC, diamond, or alumina powder. The particle size of relatively coarse abrasives separable by sieving is generally indicated by grit number, and the higher the grit number, the smaller the average particle size.
[Table 1]

| Grid number (Grid #) | 80 | 240 | 400 | 800 | 1000 | 1500 | 2000 | 3000 | 4000 | 8000 |
|---|---|---|---|---|---|---|---|---|---|---|
| Average particle size [$\mu$m] | 300 | 80 | 40 | 20 | 16 | 10 | 7.9 | 5 | 4.5-3.1 | 2-1.5 |

Polishing is generally performed using abrasives in the order of coarse size to fine size. Specular gloss starts to appear, when the grit number of the abrasive reaches about #1,000, and a visually specular state is achieved by polishing with an abrasive with a grit number of about #1,500 or more.
Various types of abrasives with average particle sizes of about 0.1 $\mu$m to about 100 $\mu$m are commercially available, specific examples of which include the products shown below.
Diamond Suspension DP-Spray (product name), manufactured by Marumoto Struers K.K., 0.25 $\mu$m to 45 $\mu$m in particle size (various types); Alumina Suspension Nos. 100 (1 $\mu$m in particle size) to 2000 (0.06 $\mu$m in particle size) (product name), manufactured by Meller (various types).

c-3) Polishing Aid

Emery may be bonded to a cloth buff with glue, cement, or the like. Glue forms a viscous liquid when dissolved in hot water. Cement is prepared by mixing a synthetic resin with sodium silicate and used to bond emery to a buff similarly to glue.
Specific examples of methods for removing large and deep asperities (several hundred micrometers to several millimeters) are shown below. The peripheral speed is preferably in the range of 1,800 to 2,400 m/minute.
[Table 2]

| Polishing tool type | Form | Abrasive type | Grit | Polishing material | Ra ($\mu$m) after polishing |
|---|---|---|---|---|---|
| Polishing cloth or paper | Sheet | Garnet Alumina Zirconia SiC | #10000-80 | Cloth | 2~0.1 |
| Polishing film | Sheet | Alumina SiC Diamond | #10000~500 | PET | 1.5~0.1 |
| Flap wheel | Wheel | Alumina SiC | #1000~500 | Cloth | 1.5~0.3 |
| Polishing brush | Wheel Roll etc. | Alumina SiC | #3000~100 | Nylon Aramid | 1.5~02 |

(continued)

| Polishing tool type | Form | Abrasive type | Grit | Polishing material | Ra (μm) after polishing |
|---|---|---|---|---|---|
| PVA grinder | Wheel Roll etc. | Alumina | #10000~3000 | Cloth | 0.1~0.3 |
| Buff | Wheel Rotating sheet | Alumina | #10000~3000 | Napped cloth | 0.1~0.3 |

In particular, an abrasive (polishing) cloth or paper and a buff are preferred in view of availability and versatility. All the polishing processes may be performed with buffs. In such a case, it is preferred that rough polishing (with grit of #400 or less) be performed with a sisal linen cloth or a cotton twill, mid-stage polishing (with a grit of #400 to #1000) with a plain weave cotton or rayon cloth, and finish polishing (with a grit of #1000 or more) with a calico, broadcloth, flannel, felt, oxhide, or the like. When the grit number is changed, the cloth should be replaced by a new one, and the polished surface be fully cleaned beforehand.

A detailed description is given in "New Practical Technology for Polishing" published by Ohmsha, Ltd., 1992, 1 st edition, pages 55 to 93.

Electrolytic-abrasive polishing may also be used in place of the mechanical polishing described above.

(Electrolytic-Abrasive Polishing)

Electrolytic-abrasive polishing is a working method including applying a direct current at a current density of preferably 0.05 to 1 A/cm$^2$, more preferably in the order of 0.1 A/cm$^2$, to a workpiece, while abrasively polishing the workpiece under a pressing pressure of 5 to 20 kPa (50 to 200 g/cm$^2$). In general electrolysis at such a current density, a thick passive film is formed on the surface of the workpiece, so that metal is hardly dissolved, and therefore the process does not proceed. Once the passive film is removed by the friction of the abrasive, however, metal is significantly dissolved from the exposed portion, so that the current efficiency rapidly increases to a level of tens to 100%. Thus, the amount of the electro-dissolution is rapidly increased by selective abrasion of micro projections by the abrasive grains, while the amount of processing of the recessed portions is close to zero, so that the surface roughness is rapidly reduced.

Not only general abrasives but also colloidal silica or colloidal alumina may be preferably used. Specifically, high purity colloidal silica PL series manufactured by Fuso Chemical Co., Ltd. may be used, such as PL-1 (primary particle size, 15 nm; secondary particle size, 40 mn), PL-3 (primary particle size, 35 nm; secondary particle size, 70 nm), PL-7 (primary particle size, 70 mm; secondary particle size, 120 nm), and PL-20 (primary particle size, 220 nm; secondary particle size, 370 nm) (all trade names). In addition, PLANERLITE (trade name) series manufactured by Fujimi Incorporated may also preferably be used.

(1) Oscar-Type Polishing Machine

When not only a certain specular rate but also a certain flatness have to be ensured, an Oscar-type polishing machine should preferably be used. An Oscar-type polishing machine, which has been used to polish optical components and so on, has such a structure that the workpiece is rotated in connection with the rotation of the tool surface plate, so that the amount of processing hardly varies with the position and that high form accuracy is easily obtained. On the other hand, electrolytic-abrasive polishing is **characterized in that** it can efficiently reduce the surface roughness. Therefore, a combination of them can achieve high-precision, high-quality mirror finish.

More specifically, electrolytic-abrasive polishing as described in Japanese Patent No. 3044377 or Japanese Patent No. 3082040 may be used.

More specifically, the method described in the text "New Practical Technology for Polishing," published by Ohmsha, Ltd., 1992, 1st edition, pages 55 to 93 may also be used.

(Chemical Polishing and Electrochemical Polishing)

In the process of manufacturing the aluminum substrate for use in an embodiment of the invention, the mechanical polishing is preferably followed by chemical polishing or electrochemical polishing as auxiliary means. As used herein, the term "auxiliary means" means that polishing is performed at a rate of change of 50% or lower of the rate of Ra change obtained by mechanical polishing.

(1) Chemical Polishing Treatment

Chemical polishing treatment may be a process including immersing the aluminum in an aqueous alkaline or acid solution to dissolve its surface. An aqueous alkali solution containing sodium carbonate, sodium silicate, or sodium phosphate alone as a primary component or an aqueous solution of any mixture thereof is preferably used. An aqueous acid solution containing sulfuric acid, nitric acid, phosphoric acid, or butyric acid alone or an aqueous solution of any mixture thereof may be used.
After the mechanical polishing treatment, chemical polishing is preferably used as auxiliary means. Some examples are shown in the table below.
[Table 3]

| Kind of solution (Mass %) | Temperature | pH | Time |
|---|---|---|---|
| 0.5 to 2% Sodium carbonate 0.05 to 0.2% Silicate | Room temperature to 50°C | 9 to 1 2 | 10 sec. to 3 0 min. |
| 0.5 to 4% Sodium metasilicate | Room temperature to 70°C | 9 to 1 2 | 10 sec. to 30 min. |
| 0.6 to 1.8% Sodium carbonate 0.6% Sodium orthophosphate | 50 to 70 °C | 9 to 12 | 10 sec. to 30 min. |
| 0.1 to 0.5% Sodium carbonate 0.6 to 1.2% Sodium silicate | 50 to 70 °C | 9 to 12 | 10 sec. to 30 min. |

When the composition is appropriately controlled as shown above, the aluminum substrate can be gradually dissolved so that the mean surface roughness (Ra) can be reduced. Preferred specific examples of the aqueous acid solution are also shown below.
[Table 4]

| Kind of solution (Mass %) | Temperature | p H | Time |
|---|---|---|---|
| 3 to 5% Sulfuric acid | Room temperature | 1 to 0.3 | 1 to 5 min. |
| 1 to 3% Nitric acid | temperature | 2 to 0.6 | 1 to 5 min. |
| 4% chromic acid 21% Sulfuric acid | 60°C | - 1 | 1 to 5 min. |
| 5% Hydrofluoric acid 2.5% Nitric acid | Room temperature | 0 | 30 sec. to 3 min. |

Also preferred is an aqueous solution of a mixture of sulfuric acid, nitric acid, phosphoric acid, and butyric acid in the composition shown in Table 3 of the text "Surface Treatment of Aluminum," published by Uchida Rokakuho Publishing Co., Ltd., 1980, 8th edition, page 36. The Alupol method described in Met. Ind., 78 (1951), 89, in which copper nitrate is added to a liquid mixture of concentrated phosphoric acid and fuming nitric acid, is also a preferred example. Various methods as described in Table 5.2.17 of "Handbook of Aluminum Technology" (edited by Japan Light Metals Association and published by Kallos Publishing Co., Ltd., 1996) may also be used. In particular, the phosphoric acid-nitric acid method is preferred.

(2) Electrochemical Polishing Treatment

Electrochemical polishing treatment is a process including dissolving and removing surface asperities from the aluminum sheet in an electrolyte, while generally applying a direct current. Preferred examples of the electrolyte include aqueous acid solutions of hydrogen peroxide, glacial butyric acid, phosphoric acid, sulfuric acid, nitric acid, chromic acid, or sodium dichromate alone, or aqueous acid solutions of any mixture thereof. In addition, ethylene glycol monoethyl ether, ethylene glycol monobutyl ester, or glycerin may also be used as an additive. Such an additive is effective in stabilizing the electrolyte and extending the range where the electrolysis can be properly performed against the concentration change, the change over time, or the degradation during use.

(3) Electrolytic Polishing

After the mechanical polishing treatment, electrolytic polishing is preferably used as auxiliary means. Preferred examples of the electrolysis conditions are shown in the table below.
[Table 5]

| Electrolyte | Temperature | Time, min. | Wave form | Voltage V | Current A/dm$^2$ |
|---|---|---|---|---|---|
| 15 to 25% Aqueous solution of perchloric acid (Specific gravity 1.48) 70 to 80% Glacial butyric acid | 50 °C or less | 10 to 20 | Direct current | 50 to 100 | 3 to 5 |
| 40 to 60 vol% Phosphoric acid<br><br>5 to 30 vol% Sulfuric acid<br><br>15 to 20 vol% Water<br><br>0 to 35 vol% Ethylene glycol monoethyl ether | 40 to 70 °C | 3 to 10 | Direct current | 10 to 30 | 3 to 60 |

Also preferred are the polishing conditions shown in Table 6 of the text "Surface Treatment of Aluminum," published by Uchida Rokakuho Publishing Co., Ltd., 1980, 8th edition, page 47. Various methods as described in Table 5.2.17 of "Handbook of Aluminum Technology" (edited by Japan Light Metals Association and published by Kallos Publishing Co., Ltd., 1996) may also be used.
In view of availability and safety of the solution to be used, the Battelle method (see British Patent No. 526854 (1940) or British Patent No. 552638 (1943)) or the phosphoric acid bath method (see Japanese Patent No. 128891 (filed in 1935, JP-B-13-004757)) is preferred.

(Finish Polishing)

The process of manufacturing the aluminum substrate for use in an embodiment of the invention preferably includes performing mechanical polishing, then performing chemical polishing and/or electrolytic polishing as auxiliary means, and then performing CMP (chemical mechanical polishing) or barrier film removing method as auxiliary means.

(1) CMP Method

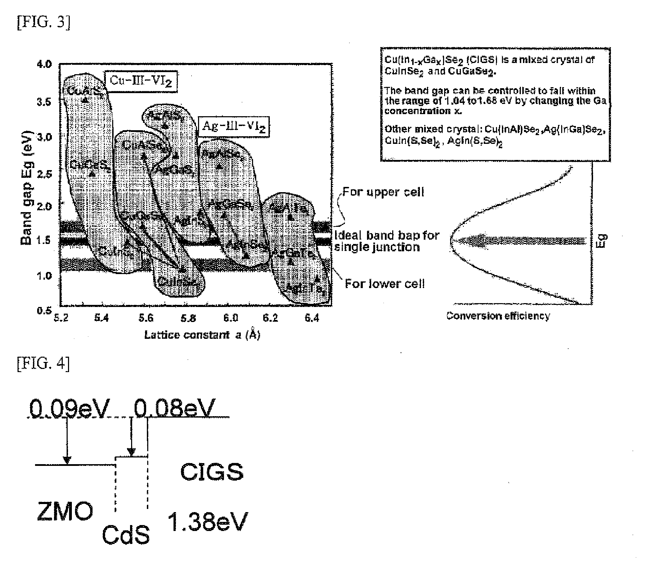

The CMP method is a combination of mechanical polishing and chemical polishing, which is generally used in semiconductor processes. It may also be used to polish the aluminum substrate, as long as the aluminum substrate has been sufficiently polished to have a flat mirror surface. Alumina or silica slurry is generally used in polishing metal such as aluminum. Colloidal alumina or colloidal silica may be used, examples of which include high purity colloidal silica PL series manufactured by Fuso Chemical Co., Ltd. and PLANERLITE series manufactured by Fujimi Incorporated (all trade names). An appropriate amount of $H_2O_2$, $Fe(NO_3)_2$ or $KIO_3$ may also be added as an additive. In order to prevent scratches or burying of the abrasive, the metal surface has to be oxidized by the additive during the polishing. Therefore, an acidic slurry having a controlled pH of 2 to 4 is generally preferred. The abrasive preferably has a primary particle size in the range of 5 nm to 2 $\mu$m, and the slurry concentration is preferably in the range of 2 to 10 vol%. In order to prevent scratches, soft CMP pads are preferably used. Examples include CMP pads XHGM-1158 and XHGM-1167 (all trade names) manufactured by Rodel Nitta.
Also use may be methods described in the text: Kazuo Maeda, "Introduction of Semiconductor Manufacturing Equipment," published by Kogyo Chosakai Publishing Co., Ltd. March, 1999 (page 171, Fig. 3.44, "Basic Principle of CMP Method and Apparatus Structure" and page 172, Fig. 3.45, Structure of CMP Apparatus).
The CMP method allows high-precision polishing but requires expensive equipment and complicated selection of the abrasive or the additive or complicated setting of polishing conditions. Alternatively, therefore, a barrier film removing method may be used for finish polishing.

(Anodic Oxidation)

In general, the anodizing treatment conditions preferably include an electrolyte concentration of 0.1 to 1% by material weight of solution, a solution temperature of 5 to 70°C, DC, a current density (direct current) of 1 to 50 A/dm$^2$, a voltage of 1 to 200 V, and an electrolysis time of 0.3 to 500 minutes, while they vary with the electrolyte used and is not automatically determined. In particular, an anodizing method using, as an electrolyte, a solution of sulfuric acid, phosphoric acid, oxalic acid, or mixture thereof is preferred. An anodizing method is more preferably performed in an electrolyte with a sulfuric, phosphoric or oxalic acid concentration of 0.1 to 1% by material weight at a temperature of 0 to 50°C with a direct current at a current density of 10 to 45 Adm$^{-2}$ and a voltage of 10 to 150 V.

<Pore Widening Treatment>

In the anodizing process, the pore size is generally set in the range of 10 nm to 150 nm. In order to obtain an anodic oxide film having larger pore sizes, therefore, pore widening treatment is performed. Pore widening treatment conditions are preferably in the range described below. When the treatment is performed with an aqueous acid solution, a specifically preferred range of conditions is such that an aqueous solution of an inorganic acid such as sulfuric acid or phosphoric acid or a mixture thereof should be used at a concentration of 10 to 500 g/l for an immersion treatment time of 3 to 60 minutes. When the treatment is performed with an aqueous alkali solution, an aqueous solution of sodium hydroxide, potassium hydroxide, lithium hydroxide, or any mixture thereof is preferably used at a pH of 9 to 13 and a temperature of 10 to 90°C for an immersion treatment time of 3 to 60 minutes.

The anodic oxide film formed on each side by the above method has a thickness of 1 $\mu$m to 200 $\mu$m. If the anodic oxide film is too thick, it may be cracked by thermal stress generated during heating in the process of forming a solar cell. Therefore, the thickness is appropriately 100 $\mu$m or less, preferably 70 $\mu$m or less, more preferably 50 $\mu$m or less. In view of thermal expansion reduction and insulating properties, the thickness is preferably 10 $\mu$m or more, more preferably 30 $\mu$m or more.

The thickness of a barrier layer is from 5 nm to 150 nm, and in order to impart a sufficient withstand voltage to the substrate for a solar cell, it is preferably 20 nm or more, more preferably 40 nm or more.

The density of the pores formed on the anodic oxide film is generally from 10 to 2200 per $\mu$m$^2$. In view of maintaining insulating properties, the pore density is preferably 1000 per $\mu$m$^2$ or less, more preferably 500 per $\mu$m$^2$ or less.

Since the thermal expansion coefficient of aluminum is $22 \times 10^{-6}$/K, there is a difference in thermal expansion between the anodic oxide film, which is alumina, and aluminum. Thus, the anodic oxide film is more preferably formed on each of both surfaces of the substrate. By making a difference in thickness between two insulating films small, the extents of thermal strains on both the surfaces of the substrate can be made equal to each other so that the generation of a warp, curling or film-peeling can be prevented. Thus, anodic oxide films equal in thickness are preferably formed on both sides of the substrate. Considering that a photoelectric conversion layer is formed on one of the surfaces of the substrate, it is more preferred that the anodic oxide film (alumina) on the surface on which no photoelectric conversion layer is formed is made thicker than the other surface for keeping balance of thermal strain between both sides of the substrate. In view of the thickness of the photoelectric conversion layer of about 3 $\mu$m, it is preferable that the thickness of the insulating film on the rear surface side is larger than that of the insulating film on the other side formed the photoelectric-transducing-layer. The difference in film thickness between the anodic oxide films on both the surfaces is preferably from about 0.001 to 5 $\mu$m, more preferably from 0.01 to 3 $\mu$m, further more preferably from 0.1 to 1 $\mu$m. The method for anodizing both the surfaces may be, for example, a method of coating an insulating material on one of the surfaces, and anodizing the surfaces one by one, and a method of anodizing both the surfaces simultaneously.

The anodic oxidation process may include placing the aluminum substrate in an electrolytic bath containing an electrolyte (electrolytic solution) and applying a voltage between the aluminum substrate and the electrode to energize the substrate so that anodic oxidation is performed. When the electrode is placed to one side of the aluminum substrate, the anodic oxide film is grown only on one side. Therefore, the anodic oxidation may be performed on each side (twice in total), so that both sides can be anodized. For example, the apparatus described in JP-A-2001-140100 or JP-A-2000-17499 may be used. When electrodes are placed to both sides of the aluminum substrate, both sides can be simultaneously anodized. In this case, the voltage applied to both sides may be controlled, or the current flow may be controlled by controlling the distance between each electrode and the aluminum substrate. In this case, alternatively, the concentration, temperature and/or components of the electrolytic solution on each of the front and back sides of the aluminum substrate may be controlled so that the thickness and quality of the anodic oxidation layer can be controlled on both sides. In addition, the anodic oxide film is more preferably formed on the metal end faces.

<Sealing Treatment>

In the invention, the first insulating oxide film (anodic oxide film) is formed onto the aluminum sheet (substrate) as described above, and then pore sealing treatment is conducted for forming a second insulating film on the anodic oxide film, thereby sealing pores generated in the anodic oxidation. According to the sealing treatment of anodic oxide film, voltage resistance and insulation resistance are improved so that the substrate for a solar cell becomes excellent in insulating property. By using an aqueous solution containing alkali metal ions as a sealing solution, or by sealing the pores with an alkali-metal-ion-containing compound, the alkali metal ions are incorporated into the pores to be sealed. According to this treatment, at the time of annealing a CIGS layer to be formed on the insulating layer, the alkali metal ions (preferably, sodium ions) are diffused into the CIGS layer. Thus, the conversion efficiency of the solar cell is improved.

In an embodiment of the present invention, a sealing ratio is used as an index of pore sealing by the pore sealing treatment.

The sealing ratio indicates the rate of reduction in the surface area of the anodic oxide film in the case of water vapor sealing (steam sealing), metal salt sealing, PVD or CVD treatment, or coating treatment as described below, or indicates the rate of reduction in the pore depth of the anodic oxide film in the case of pore sealing by re-anodization, and each rate is defined by the formula shown below. The sealing ratio is generally from 1% to 100% with respect to the pores produced in the anodic oxide film formed by the above method. In view of improvement in insulating properties and in view of adhesion properties to the upper layer by the anchor effect, the sealing ratio is preferably from 5% to 80%, more preferably from 10% to 70%. The sealing ratio, specifically the rate of reduction in surface area, may be controlled by the treatment conditions. For example, the sealing ratio can be increased by increasing the treatment temperature or the treatment time. The sealing ratio, specifically the rate of reduction in the pore depth, can be increased by increasing the voltage applied during re-anodization.

Sealing ratio (%) by water vapor sealing, metal salt sealing, PVD or CVD treatment, or coating treatment = [(surface area of anodic oxide film before pore-sealing treatment − surface area of anodic oxide film after pore-sealing treatment) / surface area of anodic oxide film before pore-sealing treatment] × 100

Sealing ratio (%) of pore sealing by re-anodization = [(pore depth before pore sealing treatment − pore depth after pore sealing treatment)/the pore depth before pore sealing treatment] × 100

The surface area of the anodic oxide film before and after the water vapor sealing, metal salt sealing, organic material sealing, or PVD or CVD treatment may be measured using a simple BET surface area analyzer (e.g., QUANTASORB (trade name) manufactured by Yuasa Ionics Inc.).

The pore depth before and after the pore sealing treatment by re-anodization may be measured by SEM observation of the cross-section of the anodic oxide film, in which the cross-section is formed by FIB or the like.

For such a sealing treatment, a conventionally known method may be used. Examples thereof include sealing by hydration such as hydro-thermal sealing, metal salt sealing, organic material sealing and the like; sealing by introducing an insulator or a compound containing an alkali ion into the pores by PVD or CVD; sealing by coating an insulating material or a compound containing an alkali ion, thereby embedding the pores; and sealing by re-anodization to form a barrier-type anodic oxide film. Of these examples, preferred are hydro-thermal sealing, metal salt sealing, PVD or CVD treatment, coating treatment, and pore sealing by re-anodization to form a barrier-type anodic oxide film. Hereinafter, each of the sealings will be described.

(Sealing by Hydration)

Specific examples of the sealing by hydration include a method of dipping the aluminum sheet having formed thereon an anodic oxide film in hot water.

It is preferred that the hot water contains an inorganic alkali metal salt (e.g., an alkali metal phosphate) or an organic alkali metal salt. The temperature of the hot water is preferably 80°C or more, more preferably 95°C or more, and is preferably 100°C or less.

The time for which the aluminum sheet is dipped in hot water is preferably from 10 to 60 minutes.

Other specific examples of the sealing by hydration include a method of bringing water vapor under applied pressure or normal pressure into continuous or discontinuous contact with the anodic oxide film (hereinafter, simply referred to as a "steam sealing or water vapor sealing").

The treating temperature for water vapor sealing is preferably from 90 to 110°C, more preferably from 95 to 105°C. If the temperature is lower than 90°C, it is difficult that a surface structure of irregularities having a pitch of 10 to 100 nm is sufficiently formed. Thus, the adhesive property onto any layer thereon is not obtained. If the temperature is higher than 110°C, the consumption amount of the vapor becomes large so that economical efficiency lowers. The treatment time for water vapor sealing is preferably from 5 to 60 seconds, more preferably from 10 to 30 seconds. As for such a water vapor sealing, it is particularly preferred to use the methods described in JP-A-6-1090, JP-A-5-179482 and JP-A-5-202496.

(Metal Salt Sealing)

The metal salt sealing is a sealing treatment with an aqueous solution containing a metal salt. The sealing solution, sealing process, the concentration controlling method and the waste liquid treatment for use in the metal salt sealing are described in detail below.

Sealing Solution

The metal salt for use in the metal salt sealing is suitably a metal fluoride. Specific examples thereof include sodium fluoride, potassium fluoride, calcium fluoride, magnesium fluoride, sodium fluorozirconate, potassium fluorozirconate, sodium fluorotitanate, potassium fluorotitanate,, potassium fluorotitanate, fluorozirconic acid, fluorotitanic acid, hexafluorosilicic acid, nickel fluoride, ferric fluoride, fluorophosphoric acid and ammonium fluorophosphates. These may be used alone or in combination of two or more thereof. From the viewpoint of the incorporation of alkali ions into the pores, out of these examples, preferred are sodium fluoride, potassium fluoride, calcium fluoride, magnesium fluoride, sodium fluorozirconate, potassium fluorozirconate, sodium fluorotitanate, potassium fluorotitanate, and potassium fluorotitanate. More preferred are sodium fluoride, sodium fluorozirconate, and sodium fluorotitanate.

The aqueous solution containing the metal salt may further contain a phosphate compound. When the solution contains the phosphate compound, the pore-sealing treatment can be conducted at a lower temperature. Thus, costs can be decreased. Preferable examples of the phosphate compound include a phosphoric acid salts of metals such as alkali metal or alkaline-earth metal. Specific examples thereof include zinc phosphate, aluminum phosphate, ammonium phosphate, diammonium hydrogen phosphate, ammonium dihydrogen phosphate, monoammonium phosphate, monopotassium phosphate, monosodium phosphate, potassium dihydrogen phosphate, dipotassium hydrogen phosphate, calcium phosphate, ammonium sodium hydrogen phosphate, magnesium hydrogen phosphate, magnesium phosphate, ferrous phosphate, ferric phosphate, sodium dihydrogen phosphate, sodium phosphate, disodium hydrogen phosphate, lead phosphate, diammonium phosphate, calcium dihydrogen phosphate, lithium phosphate, phosphotungstic acid, ammonium phosphotungstate, sodium phosphotungstate, ammonium molybdophosphate, sodium molybdophosphate, sodium phosphite, sodium tripolyphosphate and sodium pyrophosphate. These may be used alone or in combination of two or more thereof.

From the viewpoint of the incorporation of alkali ions into the pores, out of these examples, preferred are monopotassium phosphate, monosodium phosphate, potassium dihydrogen phosphate, dipotassium hydrogen phosphate, ammonium sodium hydrogen phosphate, sodium dihydrogen phosphate, sodium phosphate, disodium hydrogen phosphate, lithium phosphate, sodium phosphotungstate, ammonium phosphomolybdate, sodium phosphomolybdate, sodium phosphite, sodium tripolyphosphate, and sodium pyrophosphate. More preferred are monosodium phosphate, ammonium sodium hydrogen phosphate, sodium dihydrogen phosphate, sodium phosphate, disodium hydrogen phosphate, sodium phosphotungstate, sodium phosphomolybdate, sodium phosphite, sodium tripolyphosphate, and sodium pyrophosphate.

In the present invention, the combination of the metal salt and the phosphate compound is not particularly limited, but the meal salt-containing aqueous solution preferably contains at least sodium fluorozirconate and contains at least sodium dihydrogen phosphate as the phosphate compound.

The temperature of the metal salt-containing aqueous solution is preferably 40°C or more, more preferably 60°C or more. If the temperature is less than 40°C, the pore-sealing property becomes worse, whereas if it exceeds 95°C, liquid evaporation in a large amount is caused and this is not practical. The aqueous solution is preferably at a pH of 3 or more, more preferably at a pH of 3.2 or more, and is preferably at a pH of 5.0 or less, more preferably at a pH or 4.5 or less, particularly preferably at a pH of 3.8 or less. If the pH is less than 3.0 or exceeds 5.0, the pore-sealing property becomes worse. It is preferred to always control the system during the pore-sealing treatment and adjust the pH by adding phosphoric acid or sodium hydroxide (NaOH).

Sealing Process

Suitable examples of the pore-sealing process include vatting using the above-described pore-sealing solution (s).

The vatting may be performed with well water or pure water (ion-exchanged water). The vatting with pure water (ion-exchanged water) is preferred so as not to become the liquid clouded during vatting due to reaction of calcium or magnesium in water with fluorine ion or phosphate ion. Water in which the metal salt and the phosphate compound used for addition are dissolved is also preferably pure water (ion-exchanged water).

In the case where the metal salt (particularly, metal fluoride) and the phosphate compound are mixed as powders, it is preferred that a metal fluoride is firstly added in order to achieve good dissociation of fluorine.

The sealing treatment is preferably performed by a dipping or spraying method. A single method may be used alone once or a plurality of times, or two or more kinds of methods may be used in combination. The spraying method is particularly preferred, because the back surface of the aluminum sheet is not treated and this brings less fatigue of the solution and decrease in the amount of chemicals used.

During sealing treatment, sodium, fluorine and/or phosphoric acid in the solution and eluted aluminum react to produce sodium fluoroaluminate ($Na_3AlF_6$, cryolite) or aluminum phosphate, thereby the solution becomes clouded. Therefore, the treatment is preferably performed while removing sodium fluoroaluminate ($Na_3AlF_6$, cryolite) or aluminum phosphate by filtration through a filter or by using a settling tank. It is more preferred to perform the treatment while always filtering the solution by using a filter. Since the filter is readily clogged, the operation is preferably performed using two or more filter systems by controlling the pressure and replacing the filter while backwashing the clogged filter to remove residual substances.

Aluminum is eluted in the sealing solution. The aluminum ion concentration in the sealing solution is preferably controlled to be from 10 to 250 mg/L, more preferably from 100 to 200 mg/L.

For controlling the aluminum ion concentration to be from 10 to 250 mg/L, the concentration is adjusted by the renewed amount of the sealing solution (addition of new solution and disposal of solution after treatment).

Also, in the sealing solution, sulfate ion increases due to carry-over of sulfuric acid from the anodization treatment step as the pre-step of the pore-sealing treatment or due to dissolution of $SO_4$ contained in the anodic oxide film. The concentration of the sulfate ion is preferably from 10 to 200 mg/L, particularly preferably from 50 to 150 mg/L. If the concentration is less than 10 mg/L, this requires to increase the renewed amount of the solution and is not profitable, whereas if it exceeds 200 mg/L, the electric conductivity of the solution is affected and the concentration cannot be exactly measured.

(Organic Material Sealing)

The organic material sealing is a treatment of sealing pores by the coating or impregnation of an organic material such as fat or synthetic resin.

In the pore-sealing step with an aqueous alkali metal ion solution, it is incorporated into the pores in the anodic oxide film. In a method for the introduction thereof into the pores, it is allowable to fill any one of the metal salts described about in the sealing treatment into the pores by sputtering or vapor deposition, and subsequently conduct sealing treatment by use of any one of the above-mentioned methods.

(PVD or CVD Treatment)

In a method for the PVD or CVD treatment, a compound containing an alkali metal is introduced into the pores, or a layer of a compound containing an alkali metal is formed onto the insulating layer by sputtering or the like. Examples of PVD include sputtering and vapor deposition. Examples of the alkali-metal-containing compound used in the PVD or CVD treatment include fluorides, sulfides, selenides, chlorides, and silicates of alkali metals. Specific examples thereof include sodium fluoride, potassium fluoride, calcium fluoride, magnesium fluoride, sodium fluorozirconate, potassium fluorozirconate, sodium fluorotitanate, potassium fluorotitanate, sodium sulfide, potassium sulfide, calcium sulfide, magnesium sulfide, sodium selenide, potassium selenide, calcium selenide, sodium chloride, potassium chloride, magnesium chloride, and sodium metasilicate. These may be used alone or in combination of two or more thereof. From the viewpoint of an improvement in the conversion efficiency based on the diffusion of the alkali metal into the photoelectric conversion layer, out of these examples, preferred are sodium fluoride, sodium fluorozirconate, sodium fluorotitanate, sodium sulfide, sodium selenide, sodium chloride, and sodium metasilicate. More preferred are sodium fluoride, sodium sulfide, sodium selenide, and sodium metasilicate.

(Coating Treatment)

The method for the coating treatment may be dipping, spin coating, spraying or the like. The material to be coated may be a sol-gel solution containing an alkoxide of a metal such as Si, Ti, Zn or Al, or a solution containing fine particles of an oxide of a metal such as Si, Ti, Zn or Al. From the viewpoint of an improvement in the insulating property, it is preferred that after the coating, the resultant is subjected to thermal treatment at 150 to 500°C, thereby forming an oxide layer.

In order to supply alkali metal to the anodic oxide film sealed by the above pore sealing treatment, the anodized aluminum surface after the pore sealing may be modified with an alkali metal compound. Examples of a modification method include a method of dipping in an alkali metal compound-containing aqueous solution and a method of spin coating of an alkali metal compound-containing aqueous solution. The alkali metal compound for supplying alkali may be a fluoride, sulfide, selenide, chloride, or silicate of alkali metal. Examples of the alkali metal compound include sodium fluoride, potassium fluoride, calcium fluoride, magnesium fluoride, sodium fluorozirconate, potassium fluorozirconate, sodium fluorotitanate, potassium fluorotitanate, sodium sulfide, potassium sulfide, calcium sulfide, magnesium sulfide, sodium selenide, potassium selenide, calcium selenide, sodium chloride, potassium chloride, magnesium chloride, sodium metasilicate, sodium molybdate, potassium molybdate, sodium phosphomolybdate, potassium phosphomolybdate, sodium silicomolybdate, potassium silicomolybdate, sodium tungstate, potassium tungstate, sodium phosphotungstate, potassium phosphotungstate, sodium silicotungstate, potassium silicotungstate, sodium vanadate, and potassium vanadate. These may be used singly or in combination of two or more thereof. Particularly in view of improvement in convention efficiency by diffusion of alkali metal into the photoelectric conversion layer, preferred examples include sodium fluoride, sodium fluorozirconate, sodium fluorotitanate, sodium sulfide, sodium selenide, sodium chloride, sodium metasilicate, sodium molybdate, sodium tungstate, and sodium vanadate, and more preferred examples include sodium fluoride, sodium sulfide, sodium selenide, sodium metasilicate, and sodium molybdate.

The pore sealing treatment is effective for any porous anodic oxide film regardless of how thick the porous anodic oxide film is.

(Pore Sealing Treatment by Re-Anodization)

An anodizing process to form a barrier type anodic oxide film may be used as the re-anodizing process. The thickness of the formable barrier type anodic oxide film is up to about 1 $\mu$m. Therefore, the thickness of the porous anodic oxide film that allows the sealing ratio to be controlled by the re-anodizing process is from 0.1 to 20 $\mu$m. To make it possible to control the sealing ratio in a wide range, it is preferably from 0.5 to 10 $\mu$m, more preferably from 0.5 to 5 $\mu$m.

The re-anodizing process may be performed using a treatment solution capable of forming a barrier type anodic oxide film and the conditions of a liquid temperature of 0 to 20°C, a voltage of 100 to 1,000 V and a constant current of 0.1 to 1 Adm$^{-2}$. After the desired voltage is reached, the applied voltage is maintained for 0 to 5 minutes.

The anodizing process liquid capable of forming a barrier type anodic oxide film may be a solution of a borate such as a solution of a mixture of boric acid and a borate such as ammonium borate or sodium borate, a solution of an adipate such as ammonium adipate, a solution of a phosphate such as ammonium dihydrogen phosphate, a solution of a tartrate, a solution of a silicate, a solution of a phthalate such as potassium hydrogen phthalate, a solution of a carbonate such as sodium carbonate, a solution of a citrate, a solution of sodium chromate, or the like.

[Solar Cell]

<Formation of Photoelectric Conversion Layer>

The solar cell of the present invention may be produced by forming a photoelectric conversion layer on the substrate for a solar cell described above.

First, both sides (surfaces) of the aluminum sheet are subjected to the treatments so that the substrate for a solar cell is produced, and then the substrate for a solar cell is dried. The drying process prevents water being contaminated into the photoelectric conversion layer. The life of the photoelectric conversion layer is prevented from being reduced by the contamination with water.

A photoelectric conversion layer is formed on the dried substrate to obtain a solar cell. The photoelectric conversion layer preferably contains a semiconductor layer composed of at least one Group Ib element, at least one Group IIIb element and at least one Group VIb element (Group I-III-VI semiconductor). It may further be bonded to a tempered glass plate with an adhesive such as ethylene vinyl acetate as described in JP-A-2007-123725, so that a solar cell module can be obtained. The photoelectric conversion layer preferably contains a semiconductor layer containing at least one element selected from the group consisting of copper (Cu), silver (Ag), gallium (Ga), indium (In), sulfur (S), selenium (Se), and tellurium (Te). The photoelectric conversion layer preferably includes a CIGS semiconductor produced by a selenization technique, a selenization/sulfurization technique, a three-stage technique, or the like. Alternatively, however, the photoelectric conversion layer may include a semiconductor including a Group IVb element(s) such as Si (Group IV semiconductor); a semiconductor composed of a Group IIIb element(s) and a Group Vb element(s) such as GaAs (Group III-V semiconductor); a semiconductor composed of a Group IIb element(s) and a Group VIb element(s) such as CdTe (Group II-VI semiconductor); or combination thereof. In the present specification, the short periodic table is used to group elements.

In the case of a Si semiconductor, amorphous silicon, a microcrystalline silicon thin film layer, a thin film of Ge-doped amorphous or microcrystalline silicon, or a tandem structure of two or more of these layers may be used to form the photoelectric conversion layer. Plasma CVD or the like may be used to form the film.

An example of the CIGS photoelectric conversion layer is shown below.

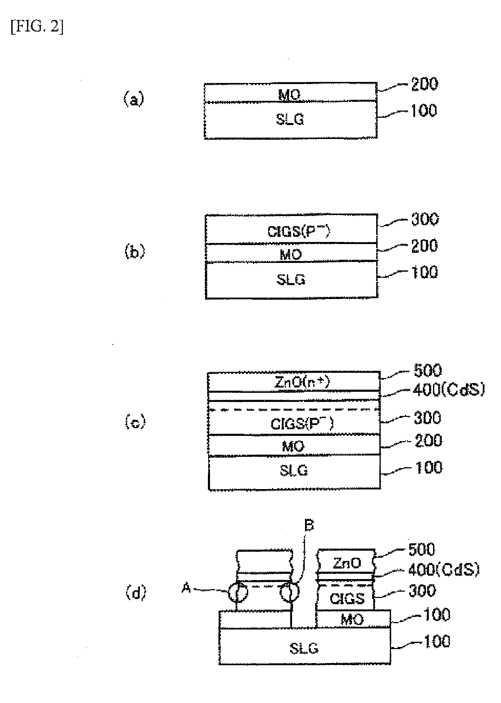

A thin-film solar cell having a light absorption layer including a chalcopyrite-structure semiconductor $CuInSe_2$ thin film (CIS thin film) composed of Group Ib elements, IIIb elements and VIb elements or $Cu(In,Ga)Se_2$ thin film (CIGS thin film), which contains a solid solution of Ga in the above semiconductor, has the advantages of high energy conversion efficiency and less degradation of the efficiency by light irradiation or the like. Figs. 2(a) to 2(d) are each a cross-sectional view of a device for illustrating a general method of producing cells of a CIGS thin-film solar battery cell.

As shown in Fig. 2(a), a Mo (molybdenum) electrode layer 200 to serve as a lower electrode on the plus side is first formed on an anodized aluminum substrate 100. As shown in Fig. 2(b), a light absorption layer 300 including a CIGS thin film and having a controlled composition to show $p^-$ type is then formed on the Mo electrode layer 200. As shown in Fig. 2(c), a buffer layer 400 of CdS or the like is then formed on the light absorption layer 300, and a light-transmitting electrode layer 500 to serve as an upper electrode on the minus side, which includes ZnO (zinc oxide) and is doped with an impurity to show $n^+$ type, is formed on the buffer layer 400. As shown in Fig. 2(d), a mechanical scribing apparatus is then used to scribe the part from the light-transmitting ZnO electrode layer 500 to the Mo electrode layer 200 at a time, so that the respective cells of a thin-film solar cell are electrically isolated from one another (namely, the cells are each individualized).

Materials that may preferably be used to form films in apparatuses for the production of this exemplary embodiment are shown below.

(1) Materials including elements, compounds or alloys each capable of forming a liquid phase at ordinary temperature or upon heating.

(2) Chalcogen Compounds (compounds containing S, Se or Te)

Group II-VI Compounds: ZnS, ZnSe, ZnTe, CdS, CdSe, CdTe, etc.
Group I-III-VI$_2$ Compounds: $CuInSe_2$, $CuGaSe_2$, $Cu(In,Ga)Se_2$, $CuInS_2$, $CuGaSe_2$, $Cu(In,Ga)(S,Se)_2$, etc.
Group I-III$_3$-VI$_5$ Compounds: $CuIn_3Se_5$, $CuGa_3Se_5$, $Cu(In,Ga)_3Se_5$, etc.

(3) Chalcopyrite-Structure Compounds and Defect Stannite Structure Compounds

Group I-III-VI$_2$ Compounds: $CuInSe_2$, $CuGaSe_2$, $Cu(In,Ga)Se_2$, $CuInS_2$, $CuGaSe_2$, $Cu(In,Ga)(S,Se)_2$, etc.
Group I-III$_3$-VI$_5$ Compounds: $CuIn_3Se_5$, $CuGa_3Se_5$, $Cu(In,Ga)_3Se_5$, etc.

In the above, (In,Ga) and (S,Se) mean $(In_{1-x}Ga_x)$ and $(S_{1-y}Se_y)$, respectively, wherein x and y each represent 0 to 1.

Typical methods for forming CIGS layers are described below, which are not intended to limit the scope of the invention.

1) Multi-Source Simultaneous Vapor Deposition

Typical methods of multi-source simultaneous vapor deposition include the three-stage method developed by NREL (National Renewable Energy Laboratory) in the United State and the simultaneous vapor deposition method by EC group. For example, the three-stage method described in J. R. Tuttle, J. S. Ward, A. Duda, T. A. Berens, M. A. Contreras, K. R. Ramanathan, A. L. Tennant, J. Kaene, E. D. Cole, K. Emery, and R. Nourfi: Mat. Res. Soc. Symp. Rroc., Vol. 426 (1996), p. 143. For example, the simultaneous vapor deposition method is described in L. Stolt et al.: Proc. 13th ECPVSEC (1995, Nice), 1451.

A three-stage method may include first simultaneously vapor-depositing In, Ga and Se under high vacuum at a substrate temperature of 300°C, then simultaneously vapor-depositing Cu and Se at a raised temperature of 500 to 560°C and then further simultaneously vapor-depositing In, Ga and Se, so that a graded band gap CIGS film having a graded band gap is obtained. The EC group method is an improvement of the bilayer process developed by The Boeing Company which includes vapor-depositing Cu-excess CIGS at an early stage and vapor-depositing In-excess CIGS at a later stage. The improvement makes the bilayer process applicable to in-line process. The bilayer process is described in W. E. Devaney, W. S. Chen, J. M. Stewart, and R. A. Mickelsen: IEEE Trans. Electron. Devices 37 (1990) 428.

The three-stage method and the EC group simultaneous vapor deposition produce a Cu-excess CIGS film composition in the course of film growth and employ liquid phase sintering of a phase-separated liquid phase $Cu_{2-x}Se$ (x=0-1). Therefore, they have the advantage that a large grain size is produced, so that a CIGS film with favorable crystallinity is formed.

In recent years, various processes for improving the crystallinity of the CIGS film have been studied in addition to these methods. Such processes may also be used.

(a) Method Using Ionized Ga

The method includes allowing vaporized Ga to pass through a grid in which thermionic ions generated from a filament is present, so that Ga collides with the thermion to be ionized. The ionized Ga is accelerated by an extraction voltage and supplied to the substrate. A detailed description is given in H. Miyazaki, T. Miyake, Y. Chiba, A. Yamada, M. Konagai, Phys. Stat. Sol. (a), Vol. 203 (2006) p. 2603.

(b) Method Using Cracked Se

In general, vaporized Se forms a cluster. This method includes thermally decomposing the Se cluster by a high-temperature heater to reduce the molecular size of the Se cluster (Proceedings of the 68th Meeting of the Japan Society of Applied Physics (Hokkaido Institute of Technology, autumn, 2007) 7P-L-6).

(c) Method Using Se Radical

This method is performed using Se radicals generated from a valve tracking system (Proceedings of the 54th Meeting of the Japan Society of Applied Physics (Aoyama Gakuin University, spring, 2007) 29P-ZW-10).

(d) Method Using Photo-Excitation Process

This method includes applying a KrF excimer laser beam (wavelength 248 nm, 100 Hz) or a YAG laser beam (e.g., wavelength 266 nm, 10 Hz) to the substrate surface during three-stage vapor deposition (Proceedings of the 54th Meeting of the Japan Society of Applied Physics (Aoyama Gakuin University, spring, 2007) 29P-ZW-14).

2) Selenization Technique

The selenization technique is also called a two-stage method, which includes first forming a metal precursor of a laminated film such as Cu layer/In layer or (Cu-Ga) layer/In layer by sputtering, vapor deposition, electrodeposition, or the like and heating the metal precursor at about 450 to about 550°C in a selenium vapor or hydrogen selenide so that a selenium compound such as $Cu(In_{1-x}Ga_x)Se_2$ is produced by a thermal diffusion reaction. This method is called vapor phase selenization. Besides this method, there is a solid-phase selenization technique which includes depositing solid-phase selenium on a metal precursor film and performing selenization by a solid phased diffusion reaction using the solid-phase selenium as a selenium source. At present, only one method is successful for large area mass production, which includes forming a metal precursor film by a sputtering method suitable for large-area production and selenizing it in hydrogen selenide.

However, this method has a problem in which during selenization, the film expands to about twice its volume, so that internal distortion is generated and that about few $\mu$m voids are formed on the produced film, which have an adverse effect on the adhesion of the film to the substrate or the solar cell characteristics to cause restriction of photoelectric conversion efficiency (B. M. Basol, V. K. Kapur, C. R. Leidholm, R. Roe, A. Halani, and G. Norsworthy: NREL/SNL Photovoltaics Prog. Rev. Proc. 14th Conf.-A Joint Meeting (1996) AIP Conf. Proc. 394).

In order to avoid the abrupt volume expansion during selenization, there are proposed a method of previously mixing a certain amount of selenium into the metal precursor film (T. Nakada, R. Ohnishi, and A. Kunioka: "CuInSe2-Based Solar Cells by Se-Vapor Selenization from Se-Containing Precursors" Solar Energy Materials and Solar Cells 35 (1994) 204-214) and use of a multilayer precursor film including metal thin layers with selenium interposed therebetween (such as a laminate of Cu layer/In layer/Se layer...Cu layer/In layer/Se layer) (T. Nakada, K. Yuda, and A. Kunioka: "Thin Films of CuInSe2 Produced by Thermal Annealing of Multilayers with Ultra-Thin Stacked Elemental Layers" Proc. Of 10th European Photovoltaic Solar Energy Conference (1991) 887-890). The problem of the volume expansion is overcome to a certain extent by these techniques.

However, all the selenization techniques including these techniques have a certain problem, which is that the degree of freedom of film composition control is very low, because a metal laminated film having a specific composition is first used and then subjected to selenization. For example, a current high-efficiency CIGS solar cell uses a graded band gap CIGS thin film in which the Ga concentration is graded in the thickness direction. A method for producing such a thin film by selenization technique includes first depositing a Cu-Ga alloy film, depositing an In film thereon, and selenizing the laminate using spontaneous thermal diffusion so that the Ga concentration can be graded in the thickness direction (K. Kushiya, I. Sugiyama, M. Tachiyuki, T. Kase, Y. Nagoya, O. Okumura, M. Sato, O. Yamase, and H. Takeshita: Tech. Digest 9th Photovoltaic Science and Engineering Conf. Miyazaki, 1996 (Intn. PVSEC-9, Tokyo, 1996) p. 149).

3) Sputtering Method

Since sputtering is suitable for large area production, many techniques have been proposed to form $CuInSe_2$ thin films. For example, there are disclosed a method using a $CuInSe_2$ polycrystal as a target and a two-source sputtering method using $Cu_2Se$ and $In_2Se_3$ as targets and $H_2Se$-Ar mixed gas as sputtering gas (J. H. Ermer, R. B. Love, A. K. Khanna, S. C. Lewis, and F. Cohen: "CdS/CuInSe2 Junctions Fabricated by DC Magnetron Sputtering of Cu2Se and In2Se" Proc. 18th IEEE Photovoltaic Specialists Conf. (1985) 1655-1658). Three-source sputtering methods are also reported in which a Cu target, an In target and a Se or CuSe target are sputtered in Ar gas (T. Nakada, K. Migita, A. Kunioka: "Polycrystalline CuInSe2 Thin Films for Solar Cells by Three-Source Magnetron Sputtering" Jpn. J. Appl. Phys. 32 (1993) L1169-L1172 and T. Nakada, M. Nishioka, and A. Kunioka: "CuInSe2 Films for Solar Cells by Multi-Source Sputtering of Cu, In, and Se-Cu Binary Alloy" Proc. 4th Photovoltaic Science and Engineering Conf. (1989) 371-375).

4) Hybrid Sputtering Method

If the above sputtering methods have the problem of film surface damage by Se negative ions or high-energy Se particles, the problem should be avoided by converting only Se into hot vapor. Nakada et al. fabricated a CIS solar cell with a conversion efficiency of higher than 10% by forming a less-defective CIS thin film by a hybrid sputtering method in which Cu and In metal are sputtered by DC, while only Se is vapor-deposited (T. Nakada, K. Migita, S. Niki, and A. Kunioka: "Microstructural Characterization for Sputter-Deposited CuInSe2 Films and Photovoltaic Devices" Jpn. Appl. Phys. 34 (1995) 4715-4721). Prior to this, Rockett et al. reported a hybrid sputtering method to use Se vapor in place of toxic $H_2Se$ gas (A. Rockett, T. C. Lommansson, L. C. Yang, H. Talieh, P. Campos, and J. A. Thornton: Proc. 20th IEEE Photovoltaic Specialists Conf. (1988) 1505). Even more before, a method of sputtering in Se vapor to complement a Se-deficient film with Se (S. Isomura, H. Kaneko, S. Tomioka, I. Nakatani, and K. Masumoto: Jpn. J. Appl. Phys. 19 (Suppl. 19-3) (1980) 23).

5) Mechanochemical Process

This process includes adding raw materials each with the corresponding composition for CIGS to the vessel of a planetary ball mill, mixing the raw materials by mechanical energy to obtain CIGS powder, then applying the powder to the substrate by screen printing, and annealing the print to obtain a CIGS film (T. Wada, Y. Matsuo, S. Nomura, Y. Nakamura, A. Miyamura, Y. Chia, A. Yamada, M. Konagai, Phys. Stat. Sol (a), Vol. 203 (2006) p2593).

6) Other Methods

Other CIGS film forming methods include a screen printing method, a close-spaced sublimation method, an MOCVD method, a spray method, and so on.
A thin film of fine particles composed of a Group Ib element, a Group IIIb element, a Group VIb element, and compounds thereof is formed on the substrate by a screen printing method, a spray method or the like and then subjected to heating such as heating in a Group VIb element atmosphere, so that a crystal with the desired composition is obtained. For example, oxide fine particles are applied to form a thin film, and then the thin film is heated in a hydrogen selenide atmosphere. A thin film of PVSEC-17 PL5-3 or an organometallic compound containing a metal-Group VIb element bond is formed on the substrate by spraying or printing and then thermally decomposed, so that the desired inorganic thin film is obtained. In the case of S, for example, the compounds listed below may be used (see for example JP-A-09-74065 and JP-A-09-74213). Metal mercaptide, metal thioate, metal dithioate, metal thiocarbonate, metal dithiocarbonate, metal trithiocarbonate, metal thiocarbamate, or metal dithiocarbamate.

(Band Gap Value and Control of Distribution Thereof)

Semiconductors of various combinations of Group I-III-VI elements may be used for the light absorption layer of the solar cell. Fig. 3 shows well-known semiconductors. Fig. 3 is a diagram showing the relationship between the lattice constant and the band gap of semiconductors composed of Group Ib elements, IIIb elements and VIb elements. Various band gaps can be obtained by changing the composition ratio. When a photon incident on a semiconductor has energy greater than the band gap, the excess energy with respect to the band gap is lost as heat. A theoretical calculation indicates that a certain combination of a sunlight spectrum and a band gap of about 1.4 to 1.5 eV can provide a maximum conversion efficiency. In order to increase the conversion efficiency of a CIGS solar cell, for example, the Ga concentration of $Cu(In_xGa_{1-x})S_2$, the Al concentration of $Cu(In_xAl_x)S_2$ or the S concentration of $CuInGa(S,Se)$ may be increased so that a high-conversion-efficiency band gap can be obtained. The band gap of $Cu(In_xGa_{1-x})S_2$ may be controlled to be in the range of 1 to 1.68 eV.

The band structure may also be biased by changing the composition ratio in the film thickness direction. There may be two graded band gap structures including: a single graded band gap structure in which the band gap increases in the direction from the light incidence window side to the opposite electrode side; and a double graded band gap structure in which the band gap decreases in the direction from the light incidence window to the PN junction and increases beyond the PN junction. For example, such solar batteries are disclosed in T. Dullweber, A new approach to high-efficiency solar cells by band gap grading in Cu(In,Ga)Se2 chalcopyrite semiconductors, Solar Energy Materials & Solar Cells, Vol. 67, p. 145-150 (2001). In all the cases, the carrier induced by light is accelerated by the internal electric field generated by the graded band structure so that it can easily arrive at the electrode, which decreases the probability of the coupling to the recombination center and therefore increases the power generation efficiency (reference literature: WO2004/090995).

(Tandem Type)

When different semiconductors with different band gaps are used for different spectrum ranges, the heat loss due to the difference between the photon energy and the band gap can be reduced so that the power generation efficiency can be increased. Such a structure using a laminate of different photoelectric conversion layers is called tandem type. In the case of a two-layer tandem, for example, a combination of 1.1 eV and 1.7 eV may be used to improve the power generation efficiency.

(Structures Other Than Photoelectric Conversion Layer)

Group II-VI compounds such as CdS, ZnO, ZnS, and Zn(O,S,OH) may be used as n-type semiconductors to form a junction with the Group I-III-VI compound semiconductor. These compounds are preferred, because they can form a junction interface free from recombination between the photoelectric conversion layer and the carrier. See for example JP-A-2002-343987.

As the back surface electrode, metal such as molybdenum, chromium, or tungsten may be used. These metal materials are preferred, because they are not susceptible to being mixed with other layers even in heat treatment. When a photovoltaic layer including a Group I-III-VI compound semiconductor layer (light absorption layer) is used, a molybdenum layer is preferably used. On the back surface electrode side, a recombination center is present at the interface between the light absorption layer CIGS and the back surface electrode. Therefore, if the contact area between the back surface electrode and the light absorption layer is unnecessarily excessive for electrical conduction, the power generation efficiency may be reduced. In order to reduce the contact area, for example, the electrode layer may have such a structure that an insulating material and a metal material are arranged in stripes. See for example JP-A-09-219530.

About a conventional solar cell using a glass substrate, it is reported that an alkali metal element (Na element) in sodium lime glass as the substrate is diffused into a CIGS film so that grains of CIGS film grow, and that the solar cell using the CIGS film in which the alkali metal element is diffused shows high energy conversion efficiency (M. Bodegard et al., "THE INFLUENCE OF SODIUM ON THE GRAIN STRUCTURE OF $CuInSe_2$ FILMS FOR PHOTOVOLTAIC APPLICATIONS", 12th European Photoelectromotive Force Solar Energy Conference). In the same manner as in the invention, it is preferred to diffuse an alkali metal into the CIGS film. In a method for diffusing the alkali metal element, it is allowable to form an alkali layer containing the alkali metal element onto a Mo electrode (back surface electrode) layer by vapor deposition or sputtering, as described in JP-A-8-222750; to form an alkali layer made of $Na_2S$ or the like on a Mo electrode layer by immersing, as described in a pamphlet of WO 03/069684; or to form a precursor containing In, Cu and Ga metal elements on a Mo electrode layer, and then causing an aqueous solution containing sodium molybdate to coat on this precursor, as disclosed in JP-A-2006-210424. An appropriate method may be selected from these methods in accordance with the method of forming the CIGS film. The diffusing method is not limited to these methods. The alkali metal element may be diffused by a different method.

As transparent electrodes, known materials such as ITO, ZnO:Ga, ZnO:Al, ZnO:B, and $SnO_2$ may be used. These materials are preferred, because they are highly light-transmitting and have low resistance and high carrier mobility. See for example JP-A-11-284211.

Examples of the layer structure include a superstrate type and a substrate type. When a photovoltaic layer including a Group I-III-VI compound semiconductor layer (light absorption layer) is used, a substrate type structure is preferably used, because of its high conventions efficiency.

(Buffer Layer, Window Layer and Transparent Electrode)

Examples of the buffer layer may include CdS, ZnS, ZnS (O, OH), and ZnMgO. Examples of the window layer may include various transparent conductive materials such as ZnO and ITO. If for example the Ga concentration of CIGS is raised to increase the band gap of the light absorption layer, the conduction band becomes too large as compared to the conduction band of ZnO, and therefore, as shown in Fig.4, the use of ZnMgO having large energy in the conduction band is preferable for the buffer layer. The buffer layer in the band structure including the CIGS/the buffer layer/the window layer (ZnO) can be prevented from having a spike shape (upward protrusion) and causing a drop in saturation current or a cliff shape (recess) and causing a drop in release current to lower FF, so that the power generation efficiency can be increased when the band gap is large.

(Prevention of Peeling, Adhesion Improvement)

(Application of Adhesive Layer)

A buffer layer of Ti is preferably used at the interface between Mo or W as a back surface electrode and $CuInSe_2$, Ti diffuses and reacts with Mo and Cu as a semiconductor forming element in heat treatment during formation of semiconductor, so that a chemically adhesive mechanism can be established and a high-quality ternary semiconductor thin film can be obtained with high reproducibility (see JP-A-5-315633).

A buffer layer of Ta, Cr, Nb, Ti, or titanium nitride having a thermal expansion coefficient halfway between Al and Mo may be interposed between the Mo electrode layer and an anodized aluminum substrate, so that electrode peeling attributable to the difference in expansion coefficient between Mo and Al during high temperature process can be prevented (see JP-A-06-252433 and Japanese Patent Application National Publication No. 09-503346).

In a selenization process, a thin film for buffering is formed which is made of a Group Ib metal element(s) and a Group IIIb metal element(s) and has lower Ga concentration than a precursor thin film between the precursor thin film and a Mo electrode, and further the buffering thin film and the precursor thin film are subjected to thermal treatment in a Se atmosphere, whereby an light absorption layer of a CIGS type can be formed (see JP-A-2003-188396).

(Reduction of Back Surface Electrode Junction Interface)

A comb-like or grid-type back surface electrode is preferably used. A metal electrode of Mo, W, Ti, Ta, Au, Pt, Ni, Cr, Ag, or Al is preferably used (see JP-A-09-172193 and JP-A-09-219530).

(Adjustment of Film Stress of Back Surface Electrode)

In a sputtering method, the substrate temperature, the film forming rate, sputtering gas pressure, etc. have an effect on film formability. The relationship between the metal sputtering gas pressure and the film stress and electrical resistance was examined into details by John A. Thornton and David W. Hoffman (see J. Vac. Sci. Technol., Vol. 14, No.1, Jan. /Feb. 1977). When a Mo film is so formed that compressive stress is from 0 to 0.4 GPa, the generation of $MoSe_x$ responsible for peeling of a CIS thin film and an increase in contact resistance can be reduced (see JP-A-10-135501 and JP-A-2000-12883).

(Back Surface Electrode Suitable for Na Addition)

A preferred structure includes at least two conductive layers and a Group Ia element-containing layer provided between the conductive layers, so that segregation of Na at the surface of the anodized aluminum substrate can be prevented, although the in-plane uniformity is not good. The thermal expansion coefficient of Mo in general use is small as compared to those of the CIGS film and the substrate, and therefore peeling may occur during the manufacturing process that includes a high temperature procedure such as a CIGS film forming step. As means for solving the problem of the peeling from the substrate, a method of layering Mo films was reported by John H. Schofield et al. (Thin Solid Films, 260, (1995), pp. 26-31). A multi-layer film is less likely to be peeled off. Examples of the Group Ia element-

containing layer include $Na_2S$, $Na_2Se$, $NaCl$, $NaF$, sodium molybdate, and aluminum oxide layers.

When the crystal grain size of the lowermost layer in the conductive layers is greater than the crystal grain size of the uppermost layer, the adhesion to the substrate is improved, and the layer is less likely to be peeled off from the substrate even after the high temperature process such as the step of forming films such as a compound semiconductor layer for a solar cell. On the other hand, the layer having a grain size smaller than this has better conductivity. When the lowermost layer in the conductive layers has a smaller density than that of the uppermost layer, the adhesion to the substrate is improved, and the layer is less likely to be peeled off from the substrate even after the high temperature process such as the step of forming films such as a compound semiconductor layer for a solar cell. On the other hand, the layer having a greater density than the above in the conductive layers has improved conductivity (see JP-A 2004-79858).

The back surface electrode may be formed to have two layers, for example into such a structure as CIGS/Mo/Cr/anodized aluminum substrate, the diffusion amount of Na may be controlled by the thickness of Cr, and the Mo film forming conditions may be relaxed. This facilitates both the control of the shape of the Mo surface and the achievement of high conductivity of the back surface electrode (see PVSC2008 poster 298).

(Alkaline Barrier)

A precursor containing In, Cu, and Ga metal elements is formed on a back surface electrode layer, and then the substrate coated with an aqueous sodium molybdate-containing aqueous solution is subjected to heat treatment in a $H_2Se$ gas atmosphere. A two-layer alkaline barrier layer is formed, which includes a silica layer and a first layer of a multi-layer metal back surface electrode layer (having its crystal grain size adjusted) (see JP-A-2006-210424 and JP-A-2006-165386).

A discussion about the effect of forming the alkaline barrier layer upon a solar cell characteristic reached a conclusion that the alkaline barrier layer is necessary (see David F. Dawson-Elli,el al., "Substrate Influences On CIS Device Performance," Proc.1st World Conference of Photovoltaic Energy Conversion(1995)152-155, C.Jensen, "The Study of Base Electrode/Substrate Interactions By Use of Air Anneal Imaging," Proc.13th European photovoltaic Solar Energy Conference(1995), JP-A-11-312817 and JP-A-2006-165386).

There is an example using a manufacturing process including intentionally forming an alkaline barrier layer (TiN, $Al_2O_3$, $SiO_2$, $Si_3N_4$, $ZrO_2$, $TiO_2$ or the like) capable of completely preventing diffusion of an alkaline component from a blue plate glass substrate, forming a metal back surface electrode thereon, and further forming another layer containing a necessary amount of Na to produce a solar cell. In this example, such an alkaline barrier layer is intentionally produced, the metal back surface electrode is formed thereon, and then a layer containing an necessary amount of Na, K, Li, or the like is separately produced (by adding a compound such as $Na_2S$ or $Na_2Se$ by doping) (see V.Probst,el al., "Large Area CIS Formation By Rapid Thermal Processing Of Stacked Elemental Layers," Proc. 17th European Photovoltaic Solar Energy Conference (2002) 1005-1010, V. Probst, el al., "Advanced Stacked a CIS Formation By Rapid Thermal Processing Of Stacked Elemental Layer Process For Cu(InGa)Se2 Thin Film Photovoltaic Devices", Mat. Res. Soc. Symp. Proc., Vol. 426 (1996) 165-176, J. Holz, et al.,: Proc. 12th European Photovoltaic Solar Energy Conference (1994) 1592-1595, JP-A-08-222750, JP-A-2007-266626, and JP-A-2003-318424).

In the above-described studies, an independent alkaline barrier layer including oxide, nitride or the like is formed on a blue plate glass substrate, and diffusion of the alkaline component from the blue plate glass substrate is related to the film forming methods (R. J. Araujo, el al., "Sodium Redistribution Between Oxide Phases," Journal of Non-Crystalline Solids, 197 (1996) 154-163). On the other hand, it was reported that a metal back surface electrode layer alone without an alkaline barrier layer can only partly block diffusion of an alkaline component (J. Holz, et al.: Proc. 12th European Photovoltaic Solar Energy Conference (1994) 1592-1595).

(Scribing)

In a solar cell actually used, a plurality of cells are packaged and processed as a module (panel). A plurality of unit cells are connected in series by each scribing step. In a thin-film solar cell, the number of series stages (the number of unit cells) may be changed so that the cell voltage can be changed and designed as desired. This is one of the advantages of the thin-film solar cell. When a solar cell having such an integrated structure is formed, the process includes first scribing to separate a Mo back surface electrode, second scribing to separate a light absorption layer in order to electrically connect a transparent electrode and the back surface electrode of an adjacent cell, and third scribing to separate the transparent electrode. A transparent electrode is provided on a groove formed after the second scribing so that electrical conduction is established according to conventional techniques. Alternatively, the light absorption layer may be modified by light irradiation so that conduction can be established, which can reduce the number of the scribing steps to two. The light absorption layer at the conducting portion has a greater Cu/In ratio. In other words, the layer has a p+ type or conductive characteristic with a small amount of In (see JP-A-2007-109842, JP-A-2007-123532, JP-A-2007-201304, JP-A-2007-317858, JP-A-2007-317868, JP-A-2007-317879, and JP-A-2007-317885). Disclosed conventional art related to scribing includes a technique of scraping a light absorption layer and a buffer layer by moving and pressing a tip-tapered metal needle under predetermined pressure (see JP-A-2004-115356), and a technique including applying, to a light absorption layer, a laser beam emitted from a Nd:YAG crystal excited by a continuous discharge lamp such as an arc lamp (Nd:YAG laser), so that the light absorption layer is removed and divided (see JP-A-11-312815).

In laser scribing, the capability of scraping a target depends on the energy density, the pulse time, and the wavelength. The target material is preferably used at high-light-absorption wavelength. The processing threshold power is different by an order of magnitude between 1064 nm and 532 nm. The pulse time is preferably 0.1 ns rather than 10 ns, and the processing is enabled when the energy density is at least several $J/cm^2$. The beam profile of the laser beam is preferably adjusted to prevent the upper edge of the scribed groove from being raised, and an anisotropic focused beam produced with a cylindrical lens is effective (see Optics and Lasers in Engineering 34, P. 15 (2000)).

The needle pressure for scribing is actively controlled to be constant to a target. A plurality of needles are arranged in a comb shape, so that the needles can be controlled at a time. Resistance between wires disconnected by scribing is measured to determine whether the electrode is favorable, and defective products are excluded. When cutting of the Mo electrode is unsuccessful, all the succeeding steps will be wasted. Powder or gas generated during scribing is sucked by an intake port near the needle or the laser irradiation outlet, and the powder or gas is removed using a filter if necessary (see JENOPTIK GmbH pamphlet).

In order to prevent defects from being formed in a light absorption layer by scribing stress, an underlying electrode layer (Mo), a p-type compound semiconductor thin film (CIGS thin film) having a chalcopyrite structure that serves as a light absorption layer, and an n-type light transmitting electrode layer (ZnO) are patterned by etching by photolithography, and the CIGS thin-film is subjected to two-stage etching including dry etching and wet etching, so that high precision patterning can be achieved with no damages or defects generated in the compound semiconductor crystal and with no residual liquid (see JP-A-2007-123721).

(In-Situ Monitoring)

Transition from a copper-rich composition to a copper-poor composition on a base material is detected by a sensor that detects a physical parameter related to the transition such as radiation. Using a sensor that detects the composition of elements in a vapor-deposited layer, a controller connected to the sensor regulates the flow rate from the vapor source in order to provide a CIGS layer having a homogeneous composition and a uniform thickness along the width of the base material. The thermal conductivity may be obtained from differential temperature measurement between two locations, or the thermal capacity, the resistivity, or the intensity of light reflected or transmitted by the deposited CIGS film may be used. The deposited amounts of the elements of the CIGS film are measured with an XRF (X-ray fluorescent) device, an EDX (energy diffusion X-ray spectroscopy) device, or a surface profilometer, and the total deposited amount of each element (Cu, Ga, In, Se) is measured, so that the thickness and composition of the deposited CIGS layer are determined or the relative amount of Cu to In+Ga is controlled (see Japanese Patent Application National Publication No. 2007-527121).

(Improvement of Conversion Efficiency by Increasing Back Surface Reflection Light)

A composite back surface contact layer may be formed between the substrate and the light absorption layer. At the time, the layer includes a back surface reflector layer that raises the reflectivity, a contact layer that secures an appropriate electrical characteristic for the back surface contact, and/or a conductance layer that secures low sheet resistance with respect to in-plane current (see Japanese Patent Application National Publication No. 2007-528600).

(Addition of Na)

An oxide thin film Cu-In-O:$Na_2O_2$ composed of Group Ib elements and IIIa elements and doped with a Group Ia oxide $Na_2O_2$ that serves as a dopant is deposited on a precursor layer formed by a selenization method, and then subjected to heat treatment in an atmosphere containing a Group VIa element (an Ar-hydrogen gas mixture containing $H_2Se$) (see JP-A-09-55378).

An alkaline metal such as Na is added to the first layer in a two-stage growth method (see JP-A-10-74966). The ratio of the Group Ib element to the Group III element included in the light absorption layer doped with the Group IIa element is from 0.22 or higher to 0.75 or lower in the composition used (see JP-A-10-74967).

The substrate for a solar cell of the present invention is a flexible substrate containing a metal substrate and an insulating layer provided thereon, which has excellent insulating properties and excellent adhesion between the insulating layer and a layer formed thereon. The solar cell of the present invention produced with the substrate is lightweight and flexible, producible at low cost, and less susceptible to delamination of the photoelectric conversion layer or the back side electrode, and has good voltage resistance characteristics.

EXAMPLES

The present invention will be described in more detail based on the following examples, but the invention is not intended to be limited thereby.

Example 1

The Al alloy substrates shown in Table 6 below were used. Anodic oxide films of varying thicknesses were formed on both sides of the aluminum substrates in an aqueous 0.5 M oxalic acid solution at 16°C under the anodizing conditions of a voltage of 40 V using a DC power source. The anodic oxide films were then washed with water and dried.
The substrates were then subjected to pore sealing treatment by dipping them in a solution containing sodium fluoride and phosphoric acid, which had a pH of 4.0 and was heated to 75 °C, so that anodized aluminum films of varying sealing ratios were formed.
The surface areas of the anodic oxide films before and after the pore sealing treatment were measured using a simple BET surface area analyzer (QUANTASORB (trade name) manufactured by Yuasa Ionics Inc.), and the sealing ratios were calculated according to the formula below.

$$\text{Sealing ratio (\%)} = [(\text{surface area of anodic oxide film before pore-sealing treatment} - \text{surface area of anodic oxide film after pore-sealing treatment}) / \text{surface area of anodic oxide film before pore-sealing treatment}] \times 100$$

Pore sealing treatment by re-anodization was also performed in an aqueous solution containing 0.5 M boric acid and 0.05 M sodium tetraborate at a current setting of 0.5 $Vdm^{-2}$ and a voltage setting to achieve the desired sealing ratio based on a barrier type anodic oxide film-forming rate of 1.2 nm/V, so that anodized aluminum films of varying sealing ratios were formed.
The pore depths of the anodic oxide films before and after the pore sealing treatment were determined by a process including forming cross-sections of the anodic oxide films by FIB and observing the cross-sections by SEM, and the sealing ratios were calculated according to the formula below.

$$\text{Sealing ratio (\%) of pore sealing by re-anodization} = [(\text{pore depth before pore sealing treatment} - \text{pore depth after pore sealing treatment})/\text{the pore depth before pore sealing treatment}] \times 100$$

A Mo electrode (1 $\mu$m in thickness) of a size of 3 cm x 3 cm was formed by sputtering on the anodic oxide film of each produced anodized aluminum substrate (substrate for a solar cell).

<Interface Peeling>

The peeling resistance of the Mo electrode formed on the insulating layer of each anodized aluminum substrate obtained as described above was evaluated by a process including baking the resulting support sample under the conditions of 550°C and 1 hour and then observing wrinkle-like peeling of the Mo electrode with an optical microscope (Nikon ECLIPSE LV100D (trade name) manufactured by Nikon Corporation) so that peeling at the interface between the Mo electrode and the porous layer was evaluated. The result is shown in Table 6.
As a result, no peeling was observed for the Mo electrode formed on the insulating layer of each of sample Nos. 1 to 8 in Table 6, while wrinkle-like peeling was observed for the Mo electrode of each of sample Nos. 9 and 10 with relatively high sealing ratios. It is considered that in sample Nos. 9 and 10, the pores did not produce an anchor effect because of the high sealing ratio, so that peeling of the Mo electrode occurred. Each of the substrates of Nos. 1 to 8 was successfully allowed to bow, and the bowing Mo electrode did not peel. This indicates that the substrate for a solar cell of the present invention is flexible and provides good adhesion property between the insulating layer and the layer formed thereon.

<Insulating Properties>

An aluminum electrode (400 nm in thickness) of 3 cm x 3 cm was formed by vapor deposition on the anodic oxide film on one side of each anodized aluminum substrate (substrate for a solar cell) obtained as describe above. In addition, the anodized aluminum film on the other side was scraped off.

In each of the resulting anodized aluminum substrates, a voltage was applied between the aluminum electrode formed on the anodized aluminum film and the other side portion where the anodized aluminum was partially scraped off, in order to measure the withstand voltage of the anodized film. A voltage applied when the insulation between the electrode and the metal substrate was broken down so that shorting occurred was defined as the withstand voltage. The result is shown in Table 6 below.

[Table 6]

| No. | Substrate | Anodizing | | Sealing solution | Sealing ratio (%) | Peeling of Mo electrode | Withstand voltage (V) | Insulation resistance (MΩ/cm$^2$) |
|---|---|---|---|---|---|---|---|---|
| | | Treating time of anodizing (min) | Thickness of anodized aluminum substrate (μm) | | | | | |
| 1 | 1N99 | 300 | 80 | Sodium fluoride | 50 | not observed | 1800 | 3000 |
| 2 | 1N99 | 60 | 50 | Sodium fluoride | 50 | not observed | 1200 | 1000 |
| 3 | 1050 | 60 | 10 | Sodium fluoride | 60 | not observed | 800 | 100 |
| 4 | 1050 | 60 | 10 | Sodium fluoride | 30 | not observed | 750 | 80 |
| 5 | 1050 | 60 | 10 | Sodium fluoride | 20 | not observed | 700 | 70 |
| 6 | 1050 | 30 | 5 | Sodium fluoride | 50 | not observed | 600 | 50 |
| 7 | 1N99 | 30 | 5 | Sodium fluoride | 50 | not observed | 650 | 60 |
| 8 | 1N99 | 30 | 5 | Sodium fluoride | 20 | not observed | 500 | 50 |
| 9 | 1050 | 30 | 5 | Sodium fluoride | 85 | caused | 600 | 80 |
| 10 | 1N99 | 60 | 10 | Sodium fluoride | 90 | caused | 850 | 80 |
| 11 | 1050 | 60 | 10 | Sodium fluoride | 0 | not observed | 200 | 40 |
| 12 | 1050 | 30 | 5 | Sodium fluoride | 0 | not observed | 130 | 10 |
| 13 | 1N99 | 5 | 1 | Sodium fluoride | 0 | not observed | 80 | 1 |

As is apparent from Table 6, each of sample Nos. 1 to 10 had a withstand voltage of 500 V or more and an insulation resistance of 50 MΩ or more. On the other hand, each of the substrates of Nos. 11 to 13 not subjected to the pore sealing treatment had a withstand voltage of 200 V or less and an insulation resistance of 40 MΩ or less. This is considered to be because the pore sealing reduced the volume of the pores in the anodic oxide film, so that the insulating properties were improved. The insulation resistance can be increased by increasing the thickness of the anodic oxide film, but this is rather not appropriate in view of solar cell performance. Because for example, in the case of a CIGS-based photoelectric conversion layer, Mo surface irregularities have an effect to cause a phenomenon leading to a reduction in electric generation efficiency, such as degradation in CIGS crystallinity, unevenness in crystal orientation, or an increase in defects. In each of the substrates of Nos. 9 and 10, peeling of the Mo electrode was also observed. It is apparent from the above that the substrate for a solar cell of the present invention has desirable voltage resistance and insulation resistance, thereby achieving excellent insulating properties.

Further, each resulting anodized aluminum substrate was further re-anodized, and a voltage was applied between the aluminum electrode formed on the anodized aluminum film and the other side portion where the anodized aluminum was partially scraped off, in order to measure the withstand voltage of the anodized film. A voltage applied when the insulation between the electrode and the metal substrate was broken down was defined as the withstand voltage. The results are shown in Table 7 below.

[Table 7]

| No. | Substrate | Film thickness ($\mu$m) | Sealing ratio (%) | Withstand voltage (V) | Insulation resistance (M$\Omega$/cm$^2$) | Peeling |
|-----|-----------|------------------------|-------------------|----------------------|------------------------------------------|---------|
| 1 | 1050 | 1 | 50 | 550 | 80 | not observed |
| 2 | 1050 | 1 | 70 | 580 | 100 | not observed |
| 3 | 1050 | 1 | 80 | 600 | 120 | not observed |
| 4 | 1050 | 3 | 30 | 700 | 150 | not observed |
| 5 | 1050 | 5 | 20 | 800 | 200 | not observed |
| 6 | 1050 | 10 | 10 | 1000 | 400 | not observed |
| 7 | 1050 | 20 | 5 | 1500 | 600 | not observed |
| 8 | 1050 | 0.8 | 100 | 200 | 5 | caused |
| 9 | 1050 | 1 | 3 | 300 | 6 | not observed |
| 10 | 1050 | 1 | 100 | 650 | 150 | caused |
| 11 | 1050 | 3 | 3 | 400 | 40 | not observed |
| 12 | 1050 | 5 | 0 | 130 | 10 | caused |
| 13 | 1050 | 5 | 2 | 200 | 30 | caused |

As is apparent from Table 7, each of the substrates of Nos. 1 to 7 had a withstand voltage of 500 V or more and an insulation resistance of 50 M$\Omega$ or more. On the other hand, each of the substrates of Nos. 8 and 10 with a sealing ratio of more than 80% showed peeling of the Mo electrode, although withstand voltage or insulation resistance was acceptable. Each of the substrates of Nos. 9 and 11 to 13 not subjected to the pore sealing treatment or having a sealing ratio of less than 5% had a withstand voltage of 200 V or less and an insulation resistance of 40 M$\Omega$ or less. This is considered to be because the pore sealing reduced the volume of the pores in the anodic oxide film, so that the insulating properties were improved. It is apparent from the above that the substrate for a solar cell of the present invention has desirable voltage resistance and insulation resistance, thereby achieving excellent insulating properties.

These results show that the anodized aluminum substrate of the present invention has high resistance to interface peeling and has excellent insulating properties.

Example 2

<Weight>

A CIGS solar cell was formed on each of a glass substrate, a stainless substrate, and an anodized aluminum substrate by a film forming method, and the weights of the resulting solar battery cells per 1 m$^2$ were compared with one another. As the anodized aluminum substrate, the anodized aluminum substrates No. 1 and 7 produced in Example 1 were used. In this example, disc-shaped targets of high-purity copper, indium (99.9999% in purity), high-purity Ga (99.999% in purity), and high-purity Se (99.999% in purity) were used.

The thicknesses of the glass substrate, the stainless substrate and the anodized aluminum substrate were 2 mm, 0.10 mm and 0.10 mm, respectively. A 0.8 $\mu$m thick molybdenum film was deposited on each of these substrates by sputtering. A chromel-alumel thermocouple was used as a substrate temperature monitor.

First, the main vacuum chamber was evacuated to 10$^{-6}$ Torr, and then high-purity argon gas (99.999%) was introduced into the sputtering chamber, and the pressured was controlled to 3 $\times$ 10$^{-2}$ Torr with a variable leak valve.

The CIS thin film was then formed as a light absorption layer so that a solar cell was prepared. The battery had the structure ZnO:Al film/CdS film/CIGS film/Mo film/substrate (from the light incidence side). An about 2 $\mu$m thick CIGS thin film was formed on the lower electrode. The film was produced under such conditions that the vapor deposition rate from each evaporation source was controlled at a maximum substrate temperature of 550°C. The prepared CIGS film had a thickness of about 2 $\mu$m. An about 90 nm CdS thin film was then deposited as a buffer layer by a solution growth method. A 0.6 $\mu$m thick ZnO:Al film as a transparent conductive film was formed thereon by an RF sputtering method. Finally, an Al grid electrode was formed as an upper electrode by a vapor deposition method.

The obtained solar cells were measured by weight. The results are shown in Table 8 below.

[Table 8]

| Substrate | Thickness of substrate (mm) | Weight of substrate (kg) | Weight of solar battery cell (kg) |
|---|---|---|---|
| Glass substrate | 2.0 | 5.0 | 5.1 |
| Stainless substrate | 0.10 | 0.78 | 0.9 |
| Anodized aluminum substrate (No. 1) | 0.10 | 0.25 | 0.36 |
| Anodized aluminum substrate (No. 7) | 0.10 | 0.26 | 0.4 |

As is apparent from Table 8, the solar cell produced with the anodized aluminum substrate was significantly lighter than the solar cell produced with the glass substrate. Further, the weight of the solar cell produced with the anodized aluminum substrate was successfully reduced to about half of that of the solar cell produced with the stainless substrate.

It is apparent from the result that the anodized aluminum substrate is effective in reducing the weight of a solar cell.

Example 3

<Photoelectric Conversion Characteristics>

In this example, a chalcopyrite structure CuInGaSe$_2$ thin film was formed as a CIGS thin film. In this example, an anodized aluminum substrate, a stainless substrate, and a soda-lime glass substrate were each used, on which films were formed under the same conditions as those in Example 2 to form solar cells. As the anodized aluminum substrate, the anodized aluminum substrate No. 6. 9 and 12 produced in Example 1 were used.

The characteristics of each resulting solar cell were measured, while it was irradiated with simulated sunlight at an AM of 1.5 and 100 mW/cm$^2$. As a result, the solar cells produced with the anodized aluminum substrate Nos. 6, 9 and 12, respectively, had conversion efficiencies of 14%, 7%, and 5%, respectively. The solar cells produced with the soda-lime glass substrate and the stainless substrate, respectively, had photoelectric conversion efficiencies of 13% and 5%, respectively.

It is considered that the solar cell produced with the anodized aluminum substrate No. 6 had the highest conversion efficiency, because of no peeling of the Mo electrode and Na diffusion from the substrate to the photoelectric conversion layer. On the other hand, it is considered that the conversion efficiency of the solar cell produced with the anodized aluminum substrate No. 9 was low, because peeling of the Mo electrode was observed due to the high pore sealing ratio; and that the conversion efficiency of the solar cell produced with the anodized aluminum substrate No. 12 was also low, because of no Na diffusion from the substrate to the photoelectric conversion layer.

The solar cell produced with the anodized aluminum substrate No. 6 showed a conversion efficiency higher than that of the stainless substrate solar cell with no Na diffusion and equal to or higher than that of the soda-lime glass substrate solar cell. This indicates that a solar cell with high conversion efficiency can be successfully formed using the anodized aluminum substrate of the present invention.

It is apparent from the above results, a CIGS solar cell having excellent insulating properties, flexibility and light weight at the same time can be produced using the anodized aluminum substrate of the present invention.

INDUSTRIAL APPLICABILITY

The substrate for a solar cell of the present invention is a flexible substrate containing a metal substrate and an insulating layer provided thereon, which has excellent insulating properties and excellent adhesion between the insulating layer and a layer formed thereon. Accordingly, the substrate for a solar cell of the present invention can be preferably used for a solar cell having excellent voltage resistance characteristics.

Having described our invention as related to the present embodiments, it is our intention that the invention not be limited by any of the details of the description, unless otherwise specified, but rather be construed broadly within its spirit and scope as set out in the accompanying claims.

This non-provisional application claims priority under 35 U.S.C. § 119 (a) on Patent Application No. 2007-255646 filed in Japan on September 28, 2007 and Patent Application No. 2008-088956 filed in Japan on March 30, 2008, each of which is entirely herein incorporated by reference.

## Claims

1. A substrate for a solar cell comprising a metal substrate, a first insulating oxide film formed on the metal substrate by anodic oxidation, and a second insulating film, wherein the first insulating oxide film has pores and the pores are sealed with the second insulating film at a sealing ratio of 5 to 80%.

2. The substrate for a solar cell according to Claim 1, wherein the metal substrate is a substrate containing at least one metal selected from the group consisting of aluminum, zirconium, titanium, magnesium, niobium and tantalum.

3. The substrate for a solar cell according to Claim 1 or 2, wherein the metal substrate is an aluminum substrate.

4. The substrate for a solar cell according to any one of Claims 1 to 3, wherein a thickness of the anodic oxide film is 0.1 $\mu$m to 100 $\mu$m.

5. The substrate for a solar cell according to any one of Claims 1 to 4, wherein the anodic oxide film is formed on both surfaces of the metal substrate.

6. The substrate for a solar cell according to any one of Claims 1 to 5, wherein the anodic oxide film is formed on an end face and both surfaces of the metal substrate.

7. The substrate for a solar cell according to any one of Claims 1 to 6, wherein the second insulating film contains alkali metal ions.

8. The substrate for a solar cell according to any one of Claims 1 to 7, wherein the alkali metal ions contained in the second insulating film are Na ions.

9. A solar cell comprising; the substrate for a solar cell according to any one of Claims 1 to 7; and a photoelectric conversion layer provided on the substrate for a solar cell.

10. The solar cell according to Claim 9, wherein the photoelectric conversion layer comprises a semiconductor layer comprising at least one Group Ib element, at least one Group IIIb element and at least one Group VIb element.

11. The solar cell according to Claim 9 or 10, wherein the semiconductor layer comprises at least one element selected from the group consisting of copper (Cu), silver (Ag), gallium (Ga), indium (In), sulfur (S), selenium (Se), and tellurium (Te).

[FIG. 1]

[FIG. 2]

(a)

| MO | — 200 |
| SLG | — 100 |

(b)

| CIGS($P^-$) | — 300 |
| MO | — 200 |
| SLG | — 100 |

(c)

| ZnO($n^+$) | — 500 |
| 400(CdS) |
| CIGS($P^-$) | — 300 |
| MO | — 200 |
| SLG | — 100 |

(d)

B

A

ZnO — 500
400(CdS)
CIGS — 300
MO — 100
SLG — 100

[FIG. 3]

Cu(In$_{1-x}$Ga$_x$)Se$_2$ (CIGS) is a mixed crystal of CuInSe$_2$ and CuGaSe$_2$.

The band gap can be controlled to fall within the range of 1.04 to 1.68 eV by changing the Ga concentration x.

Other mixed crystal: Cu(InAl)Se$_2$, Ag(InGa)Se$_2$, CuIn(S,Se)$_2$, AgIn(S,Se)$_2$

[FIG. 4]

## INTERNATIONAL SEARCH REPORT

| | International application No. |
|---|---|
| | PCT/JP2008/067556 |

**A. CLASSIFICATION OF SUBJECT MATTER**
*H01L31/04(2006.01)i*

According to International Patent Classification (IPC) or to both national classification and IPC

**B. FIELDS SEARCHED**

Minimum documentation searched (classification system followed by classification symbols)
H01L31/04-31/078

Documentation searched other than minimum documentation to the extent that such documents are included in the fields searched
Jitsuyo Shinan Koho           1922-1996   Jitsuyo Shinan Toroku Koho   1996-2008
Kokai Jitsuyo Shinan Koho   1971-2008   Toroku Jitsuyo Shinan Koho   1994-2008

Electronic data base consulted during the international search (name of data base and, where practicable, search terms used)
WPI, JSTPlus(JDreamII)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 61-284971 A  (Matsushita Electric Industrial Co., Ltd.),<br>15 December, 1986 (15.12.86),<br>Full text; all drawings<br>(Family: none) | 1-9<br>10,11 |
| Y<br>A | WO 2003/007386 A1  (Mid-West Research Institute),<br>23 January, 2003 (23.01.03),<br>Full text; all drawings<br>& US 2005/0074915 A1 | 10,11<br>1-9 |
| A | JP 62-089369 A  (Matsushita Electric Industrial Co., Ltd.),<br>23 April, 1987 (23.04.87),<br>Full text; all drawings<br>(Family: none) | 1-11 |

☒ Further documents are listed in the continuation of Box C.      ☐ See patent family annex.

| | |
|---|---|
| * Special categories of cited documents:<br>"A" document defining the general state of the art which is not considered   to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>20 October, 2008 (20.10.08) | Date of mailing of the international search report<br>28 October, 2008 (28.10.08) |
|---|---|
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2008/067556

C (Continuation). DOCUMENTS CONSIDERED TO BE RELEVANT

| Category* | Citation of document, with indication, where appropriate, of the relevant passages | Relevant to claim No. |
|---|---|---|
| A | JP 63-250866 A (Showa Aluminum Corp.),<br>18 October, 1988 (18.10.88),<br>Full text; all drawings<br>(Family: none) | 1-11 |
| A | JP 11-229187 A (Kobe Steel, Ltd.),<br>24 August, 1999 (24.08.99),<br>Full text; all drawings<br>(Family: none) | 1-11 |
| A | JP 2000-349320 A (Kobe Steel, Ltd.),<br>15 December, 2000 (15.12.00),<br>Full text; all drawings<br>(Family: none) | 1-11 |
| A | JP 2007-502536 A (Sandvik Intellectual<br>Property AB.),<br>08 February, 2007 (08.02.07),<br>Full text; all drawings<br>& EP 1665390 A        & WO 2005/015645 A1<br>& SE 302206 A          & KR 10-2006-0115990 A<br>& CN 1836338 A | 7-11 |

Form PCT/ISA/210 (continuation of second sheet) (April 2007)

## INTERNATIONAL SEARCH REPORT

| | International application No. |
| --- | --- |
| | PCT/JP2008/067556 |

**Box No. II     Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III     Observations where unity of invention is lacking (Continuation of item 3 of first sheet)**

This International Searching Authority found multiple inventions in this international application, as follows:
    The technical feature common to all the claims is a substrate for solar cells defined in claim 1.
    The international search, however, has revealed that the invention of claim 1 is not novel since it is disclosed in JP 61-284971 A.
    Consequently, such a substrate for solar cells is not a special technical feature within the meaning of PCT Rule 13.2, second sentence.
    The inventions of claims 1-11 therefore do not satisfy the requirement of unity of invention.

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**
the

☐ The additional search fees were accompanied by the applicant's protest and, where applicable, payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006080370 A
- JP 2006295035 A
- JP 2000349320 A
- JP 10074966 A
- JP 10074967 A
- JP 9055378 A
- JP 10125941 A
- JP 2005117012 A
- JP 2006210424 A
- JP 2003318424 A
- JP 2005086167 A
- JP 8222750 A
- JP 2004158556 A
- JP 2004079858 A
- JP A A
- JP 2003096584 A
- JP 2007030146 A
- JP 3044377 B
- JP 3082040 B
- GB 526854 A
- GB 552638 A
- JP 128891 A
- JP 1935 A
- JP 13004757 B
- JP 2001140100 A
- JP 2000017499 A
- JP 6001090 A
- JP 5179482 A
- JP 5202496 A
- JP 2007123725 A
- JP 9074065 A
- JP 9074213 A
- WO 2004090995 A
- JP 2002343987 A
- JP 9219530 A
- WO 03069684 A
- JP 11284211 A
- JP 5315633 A
- JP 6252433 A
- JP 9503346 A
- JP 2003188396 A
- JP 9172193 A
- JP 10135501 A
- JP 2000012883 A
- JP 2006165386 A
- JP 11312817 A
- JP 2007266626 A
- JP 2007109842 A
- JP 2007123532 A
- JP 2007201304 A
- JP 2007317858 A
- JP 2007317868 A
- JP 2007 A
- JP 317879 A
- JP 2007317885 A
- JP 2004115356 A
- JP 11312815 A
- JP 2007123721 A
- JP 2007527121 A
- JP 2007528600 A
- JP 2007255646 A
- JP 2008088956 A

**Non-patent literature cited in the description**

- Aluminum Handbook. Japan Light Metals Association, 1990
- New Practical Technology for Polishing. Ohmsha, Ltd, 1992, 55-93
- Surface Treatment of Aluminum. Uchida Rokakuho Publishing Co., Ltd, 1980, 36
- Handbook of Aluminum Technology. Kallos Publishing Co., Ltd, 1996
- Surface Treatment of Aluminum. Uchida Rokakuho Publishing Co., Ltd, 1980, 47
- **Kazuo Maeda.** *Introduction of Semiconductor Manufacturing Equipment,* March 1999, 171
- *Basic Principle of CMP Method and Apparatus Structure,* 172
- **J. R. Tuttle ; J. S. Ward ; A. Duda ; T. A. Berens ; M. A. Contreras ; K. R. Ramanathan ; A. L. Tennant ; J. Kaene ; E. D. Cole ; K. Emery.** *Mat. Res. Soc. Symp. Rroc.,* 1996, vol. 426, 143
- **L. Stolt et al.** *Proc. 13th ECPVSEC,* 1995, 1451
- **W. E. Devaney ; W. S. Chen ; J. M. Stewart ; R. A. Mickelsen.** *IEEE Trans. Electron. Devices,* 1990, vol. 37, 428
- **H. Miyazaki ; T. Miyake ; Y. Chiba ; A. Yamada ; M. Konagai.** *Phys. Stat. Sol. (a),* 2006, vol. 203, 2603
- *Proceedings of the 68th Meeting of the Japan Society of Applied Physics,* 2007

- *Proceedings of the 54th Meeting of the Japan Society of Applied Physics,* 2007
- Proceedings of the 54th Meeting of the Japan Society of Applied Physics. spring, 2007, 29, ZW-14
- **B. M. Basol ; V. K. Kapur ; C. R. Leidholm ; R. Roe ; A. Halani ; G. Norsworthy.** NREL/SNL Photovoltaics Prog. Rev. Proc. 14th Conf.-A Joint Meeting. *AIP Conf. Proc.,* 1996, 394
- **T. Nakada ; R. Ohnishi ; A. Kunioka.** CuInSe2-Based Solar Cells by Se-Vapor Selenization from Se-Containing Precursors. *Solar Energy Materials and Solar Cells,* 1994, vol. 35, 204-214
- **T. Nakada ; K. Yuda ; A. Kunioka.** Thin Films of CuInSe2 Produced by Thermal Annealing of Multilayers with Ultra-Thin Stacked Elemental Layers. *Proc. Of 10th European Photovoltaic Solar Energy Conference,* 1991, 887-890
- **K. Kushiya ; I. Sugiyama ; M. Tachiyuki ; T. Kase ; Y. Nagoya ; O. Okumura ; M. Sato ; O. Yamase ; H. Takeshita.** Tech. Digest 9th Photovoltaic Science and Engineering Conf. Miyazaki. *Intn. PVSEC-9, Tokyo,* 1996, 149
- **J. H. Ermer ; R. B. Love ; A. K. Khanna ; S. C. Lewis ; F. Cohen.** CdS/CuInSe2 Junctions Fabricated by DC Magnetron Sputtering of Cu2Se and In2Se. *Proc. 18th IEEE Photovoltaic Specialists Conf.,* 1985, 1655-1658
- **T. Nakada ; K. Migita ; A. Kunioka.** Polycrystalline CuInSe2 Thin Films for Solar Cells by Three-Source Magnetron Sputtering. *Jpn. J. Appl. Phys.,* 1993, vol. 32, L1169-L1172
- **T. Nakada ; M. Nishioka ; A. Kunioka.** CuInSe2 Films for Solar Cells by Multi-Source Sputtering of Cu, In, and Se-Cu Binary Alloy. *Proc. 4th Photovoltaic Science and Engineering Conf.,* 1989, 371-375
- **T. Nakada ; K. Migita ; S. Niki ; A. Kunioka.** Microstructural Characterization for Sputter-Deposited CuInSe2 Films and Photovoltaic Devices. *Jpn. Appl. Phys.,* 1995, vol. 34, 4715-4721
- **A. Rockett ; T. C. Lommansson ; L. C. Yang ; H. Talieh ; P. Campos ; J. A. Thornton.** *Proc. 20th IEEE Photovoltaic Specialists Conf.,* 1988, 1505
- **S. Isomura ; H. Kaneko ; S. Tomioka ; I. Nakatani ; K. Masumoto.** *Jpn. J. Appl. Phys.,* 1980, vol. 19 (19-3), 23
- **T. Wada ; Y. Matsuo ; S. Nomura ; Y. Nakamura ; A. Miyamura ; Y. Chia ; A. Yamada ; M. Konagai.** *Phys. Stat. Sol (a),* 2006, vol. 203, 2593
- **T. Dullweber.** A new approach to high-efficiency solar cells by band gap grading in Cu(In,Ga)Se2 chalcopyrite semiconductors. *Solar Energy Materials & Solar Cells,* 2001, vol. 67, 145-150
- *J. Vac. Sci. Technol.,* January 1977, vol. 14 (1
- **John H. Schofield et al.** *Thin Solid Films,* 1995, vol. 260, 26-31
- **David F. Dawson-Elli.** Substrate Influences On CIS Device Performance. *Proc. 1st World Conference of Photovoltaic Energy Conversion,* 1995, 152-155
- **C.Jensen.** The Study of Base Electrode/Substrate Interactions By Use of Air Anneal Imaging. *Proc. 13th European photovoltaic Solar Energy Conference,* 1995
- **V.Probst.** Large Area CIS Formation By Rapid Thermal Processing Of Stacked Elemental Layers. *Proc. 17th European Photovoltaic Solar Energy Conference,* 2002, 1005-1010
- **V. Probst.** Advanced Stacked a CIS Formation By Rapid Thermal Processing Of Stacked Elemental Layer Process For Cu(InGa)Se2 Thin Film Photovoltaic Devices. *Mat. Res. Soc. Symp. Proc.,* 1996, vol. 426, 165-176
- **J. Holz et al.** *Proc. 12th European Photovoltaic Solar Energy Conference,* 1994, 1592-1595
- **R. J. Araujo.** Sodium Redistribution Between Oxide Phases. *Journal of Non-Crystalline Solids,* 1996, vol. 197, 154-163
- *Optics and Lasers in Engineering,* 2000, vol. 34, 15